# EUROPEAN PATENT APPLICATION

(11) **EP 4 765 191 A1**
(43) Date of publication of application: **24.06.2026**
(21) Application number: 24854054.4
(22) Date of filing: 20.05.2024
(51) Int. Cl.: H01L 21/02, G05B 23/02, H01L 21/304, H01L 21/306

(54) **MONITORING METHOD IN SUBSTRATE PROCESSING APPARATUS**

(30) Priority: 17.08.2023 JP 2023132884; 01.12.2023 JP 2023203844
(71) Applicant: SCREEN Holdings Co., Ltd., Kyoto-shi, Kyoto 602-8585 (JP)
(72) Inventor: CHAUHAN, Nachiketa, Kyoto-shi, Kyoto 602-8585 (JP); YEN, Hunghsiu, Kyoto-shi, Kyoto 602-8585 (JP); SHIMIZU, Shinji, Kyoto-shi, Kyoto 602-8585 (JP)
(74) Representative: Kilian Kilian & Partner mbB
(86) International application number: PCT/JP2024/018521
(87) International publication number: WO 2025/037463

(57) **Abstract**

Provided is a technique capable of monitoring a monitoring target with higher monitoring accuracy. A monitoring method for monitoring a monitoring target in a chamber of a substrate processing apparatus that processes a substrate includes an image generation step and a monitoring step. In the image generation step, a monitoring camera receives light from a monitoring region including at least one first monitoring target among a plurality of monitoring targets in the chamber, and generates monitoring image data. After the image generation step, in the monitoring step, high-resolution image data obtained by enhancing the resolution of the monitoring image data is generated by using a learned model of resolution enhancement processing, and the first monitoring target is monitored based on the high-resolution image data.

## Description

### TECHNICAL FIELD

The present disclosure relates to a monitoring method in a substrate processing apparatus.

### BACKGROUND ART

Conventionally, in a manufacturing process of a semiconductor device or the like, various processing liquids such as pure water, a photoresist liquid, and an etching liquid are supplied to a substrate to perform various substrate processing such as cleaning processing and resist coating processing. As an apparatus for performing such substrate processing using processing liquids, a substrate processing apparatus is widely used in which a substrate holding unit rotates a substrate in a horizontal attitude and discharges a processing liquid from a nozzle to a surface of the substrate.

In such a substrate processing apparatus, whether or not the position of the nozzle is appropriate is monitored. For example, in Patent Document 1, imaging means such as a camera is provided to monitor the position of the nozzle.

### PRIOR ART DOCUMENT

### PATENT DOCUMENT

Patent Document 1: Japanese Patent Application Laid-Open No. 2015-173148

### SUMMARY

### PROBLEM TO BE SOLVED BY THE INVENTION

In order to appropriately process the substrate, it is desirable to monitor not only the nozzle but also more monitoring targets.

For example, the substrate holding unit includes a plurality of chuck pins. The plurality of chuck pins are provided at equal intervals along the peripheral edge of the substrate. Each of the chuck pins is provided to be displaceable between a holding position abutting on the peripheral edge of the substrate and a release position away from the substrate. When the chuck pin is located at the holding position, the substrate holding unit can hold the substrate. If the substrate holding unit cannot appropriately hold the substrate, the substrate cannot be appropriately processed. Therefore, the positions of the plurality of chuck pins of the substrate holding unit may be monitored.

When a camera receives light from a monitoring region including the plurality of chuck pins, an image data generated by the camera includes a plurality of chuck pins. When the camera is an imaging camera, in a case where the distances between the camera and the chuck pins in real space are different among the plurality of chuck pins, the clarity of contours of the plurality of chuck pins in the captured image data may be different from each other. For example, since a chuck pin close to the camera is included in the captured image data in a large size, the contour shape of the chuck pin tends to be clear. On the other hand, since a chuck pin far from the camera is included in the captured image data in a small size, the contour shape of the chuck pin tends to be unclear. In addition, as the chuck pin moves away from a focus position of a lens of the camera in real space, the contour shape of the chuck pin tends to be unclear in captured image data.

Furthermore, in a case where the camera is a depth camera, image data generated by the camera includes the distance to an object in a monitoring region for each pixel. Since the measurement accuracy of the depth camera is not very high, the contour shape of an object in depth image data may be unclear.

Then, if a monitoring target is monitored based on image data including the monitoring target whose contour shape is unclear, the monitoring accuracy may decrease.

Therefore, an object of the present disclosure is to provide a technique capable of monitoring a monitoring target with higher monitoring accuracy.

### MEANS TO SOLVE THE PROBLEM

A first aspect is a monitoring method for monitoring a monitoring target in a chamber of a substrate processing apparatus that processes a substrate, the monitoring method including an image generation step in which a monitoring camera receives light from a monitoring region including at least one first monitoring target among a plurality of monitoring targets in the chamber and generates monitoring image data, and a monitoring step executed after the image generation step to generate high-resolution image data obtained by enhancing resolution of the monitoring image data by using a learned model of resolution enhancement processing, and monitor the first monitoring target based on the high-resolution image data.

A second aspect is the monitoring method in a substrate processing apparatus according to the first aspect, in which in the monitoring step, the high-resolution image data is generated using a first learned model corresponding to the first monitoring target among a plurality of the learned models of the resolution enhancement processing corresponding to the plurality of monitoring targets.

A third aspect is the monitoring method in a substrate processing apparatus according to the second aspect, in which: in the image generation step, the monitoring camera receives light from the monitoring region including at least the first monitoring target and a second monitoring target among the plurality of monitoring targets and generates the monitoring image data; and the monitoring step includes a step of generating first high-resolution image data in which resolution of a first determination region not including the second monitoring target but including the first monitoring target in the monitoring image data is enhanced using the first learned model as the high-resolution image data, and generating a second high-resolution image data in which resolution of a second determination region not including the first monitoring target but including the second monitoring target in the monitoring image data is enhanced using a second learned model corresponding to the second monitoring target among the plurality of learned models, and a step of monitoring the first monitoring target based on the first high-resolution image data and monitoring the second monitoring target based on the second high-resolution image data.

A fourth aspect is the monitoring method in a substrate processing apparatus according to the second or third aspect, in which in the monitoring step, resolution of the monitoring image data is enhanced at a first resolution magnification set for the first monitoring target among a plurality of resolution magnifications set for the plurality of monitoring targets to generate the high-resolution image data.

A fifth aspect is the monitoring method in a substrate processing apparatus according to the fourth aspect, further including a training step executed before the image generation step to generate the first learned model, in which the training step includes a learning image generation step in which a high-performance camera having a resolution higher than a resolution of the monitoring camera images the first monitoring target at a plurality of timings in a state where the first monitoring target is more in focus than a second monitoring target among the plurality of monitoring targets to generate a plurality of pieces of high-resolution learning data, a resolution reduction step in which the plurality of pieces of high-resolution learning data are down-sampled at a magnification equal to or less than an inverse of the first resolution magnification and converted into a plurality of pieces of low-resolution learning data, and a model generation step of generating the first learned model based on the plurality of pieces of high-resolution learning data and the plurality of pieces of low-resolution learning data.

A sixth aspect is the monitoring method in a substrate processing apparatus according to the fifth aspect, in which in the learning image generation step, the high-performance camera images the monitoring region of the monitoring camera.

A seventh aspect is the monitoring method in a substrate processing apparatus according to the fifth or sixth aspect, in which in the learning image generation step, the first monitoring target that can be displaced is imaged at the plurality of timings at which the first monitoring target is located at different positions to generate the plurality of pieces of high-resolution learning data.

An eighth aspect is the monitoring method in a substrate processing apparatus according to the fourth aspect, further including a training step that is executed before the image generation step and generates the learned model, in which the training step includes: a learning image generation step of generating a plurality of sets of high-resolution learning data and low-resolution learning data based on three-dimensional data including information regarding a shape of the monitoring target in the chamber; and a model generation step of generating the learned model based on the plurality of sets of high-resolution learning data and low-resolution learning data.

A ninth aspect is the monitoring method in a substrate processing apparatus according to any one of the first to eighth aspects, in which the monitoring camera includes a depth camera that generates depth image data indicating a distance to the monitoring target as the monitoring image data.

A 10th aspect is the monitoring method in a substrate processing apparatus according to any one of the first to ninth aspects, in which the monitoring camera includes an imaging camera that receives visible light.

An 11th aspect is the monitoring method in a substrate processing apparatus according to any one of the first to 10th aspects, further including a reference image registration step executed before the image generation step to register reference image data, in which: the reference image registration step includes a pre-image generation step of generating pre-image data by the monitoring camera receiving light from the monitoring region, a reference image generation step of generating, after the pre-image generation step, the reference image data obtained by enhancing resolution of the pre-image data by using the learned model, and a storage step of causing a storage to record the reference image data; and in the monitoring step, the first monitoring target is monitored based on a comparison between the high-resolution image data and the reference image data.

### EFFECTS OF THE INVENTION

According to the first, ninth, and 10th aspects, since the resolution of the monitoring image data is enhanced with the learned model, it is possible to generate high-resolution image data with higher accuracy. Therefore, the first monitoring target can be monitored with higher monitoring accuracy.

According to the second aspect, since the resolution of the monitoring image data is enhanced with the first learned model corresponding to the first monitoring target, it is possible to generate high-resolution image data with higher accuracy. Therefore, the first monitoring target can be monitored with even higher monitoring accuracy.

According to the third aspect, it is not necessary to image the first monitoring target and the second monitoring target at different timings, and the number of times of operations of the monitoring camera can be reduced. Moreover, since the resolution of the second determination region is enhanced in the second learned model corresponding to the second monitoring target, it is possible to generate the second high-resolution image data with higher accuracy. Therefore, the second monitoring target can be monitored with higher monitoring accuracy.

According to the fourth aspect, it is possible to enhance the resolution of monitoring image data with higher accuracy regardless of the state of the monitoring target.

According to the fifth aspect, a plurality of pieces of high-resolution learning data is generated in a state where the first monitoring target is in focus, and the plurality of pieces of high-resolution learning data are converted into a plurality of pieces of low-resolution learning data at a magnification equal to or less than an inverse of the first resolution magnification. Therefore, it is possible to generate the first learned model suitable for enhancing the resolution of the first monitoring target at the first resolution magnification.

According to the sixth aspect, the high-performance camera captures the same monitoring region as the monitoring camera. Therefore, the optical characteristics of the lens group of the high-performance camera through which light is transmitted at the time of imaging are similar to the optical characteristics of the lens group of the monitoring camera through which light is transmitted at the time of imaging. Therefore, the high-resolution learning data of the high-performance camera can be made equivalent to the high-resolution image data obtained by enhancing the resolution of the monitoring image data of the monitoring camera. As a result, the first monitoring target can be more appropriately monitored based on the high-resolution image data.

According to the seventh aspect, the plurality of pieces of high-resolution learning data include the first monitoring target at positions different from each other, and the first learned model is generated using the plurality of pieces of high-resolution learning data. Therefore, the first learned model can generate high-resolution image data with higher accuracy.

According to the eighth aspect, a high-performance camera is not required for generating learning data. Therefore, the learned model can be generated at a low cost.

According to the 11th aspect, the resolution of the pre-image data captured by the monitoring camera is enhanced with the learned model to generate the reference image data. That is, the high-resolution image data and the reference image data are generated using the same monitoring camera and the same learned model. Therefore, the first monitoring target can be monitored with high accuracy by comparing the high-resolution image data with the reference image data.

### BRIEF DESCRIPTION OF DRAWINGS

[FIG. 1] is a plan view schematically illustrating an example of a configuration of a substrate processing apparatus.
[FIG. 2] is a block diagram schematically illustrating an example of a configuration of a controller.
[FIG. 3] is a longitudinal sectional view schematically illustrating an example of a configuration of a processing unit according to a first embodiment.
[FIG. 4] is a diagram schematically illustrating an example of monitoring image data generated by an imaging camera.
[FIG. 5] is a diagram schematically illustrating an example of monitoring image data generated by an imaging camera.
[FIG. 6] is a flowchart illustrating an example of a monitoring method by the processing unit.
[FIG. 7] is a flowchart illustrating a specific example of a monitoring process.
[FIG. 8] is a diagram illustrating an example of a flow of each piece of data in the monitoring process.
[FIG. 9] is a flowchart illustrating a first example of a specific operation of a training process.
[FIG. 10] is a diagram schematically illustrating an example of a state in which a high-performance camera is provided in a chamber.
[FIG. 11] is a diagram schematically illustrating a flow of data in generation of a learned model.
[FIG. 12] is a flowchart illustrating an example of a specific operation of a reference image registration process.
[FIG. 13] is a diagram illustrating an example of a flow of each piece of data.
[FIG. 14] is a functional block diagram illustrating an example of an internal configuration of a controller.
[FIG. 15] is a flowchart illustrating a second example of a specific operation of the training process.
[FIG. 16] is a diagram schematically illustrating an example of high-resolution learning data.
[FIG. 17] is a diagram schematically illustrating an example of low-resolution learning data.
[FIG. 18] is a longitudinal sectional view schematically illustrating an example of a configuration of a processing unit according to a second embodiment.
[FIG. 19] is a diagram schematically illustrating an example of monitoring image data.
[FIG. 20] is a diagram schematically illustrating an example of high-resolution learning data.
[FIG. 21] is a diagram schematically illustrating an example of low-resolution learning data.
[FIG. 22] is a diagram schematically illustrating an example of an operation of a controller.

### DESCRIPTION OF EMBODIMENTS

Hereinafter, an embodiment will be described in detail with reference to the drawings. Note that in the drawings, dimensions and the number of units are exaggerated or simplified as necessary for easy understanding. Portions having similar configurations and functions are denoted by the same reference numerals, and redundant description will be omitted in the following description.

Furthermore, in the following description, similar components are denoted by the same reference signs and have similar names and functions. Therefore, detailed description thereof may be omitted in order to avoid redundancy.

In addition, in the following description, even if ordinal numbers such as "first" or "second" are used, these terms are used for convenience to facilitate understanding of the contents of the embodiments, and are not intended to limit the order that can occur by these ordinal numbers.

When an expression indicating a relative or absolute positional relationship (e.g., "in one direction", "along one direction", "parallel", "orthogonal", "center", "concentric", "coaxial", or the like) is used, unless otherwise specified, the expression not only strictly represents the positional relationship, but also represents a state of being displaced relative to an angle or distance to the extent that a tolerance or the same level of function is obtained. When an expression indicating an equal state (e.g., "same", "equal", "homogeneous", or the like) is used, unless otherwise specified, the expression not only represents a quantitatively strictly equal state, but also represents a state in which there is a difference that results in a tolerance or the same level of function. When an expression indicating a shape (e.g., "quadrangular", "cylindrical", or the like) is used, unless otherwise specified, the expression not only represents the shape geometrically strictly, but also represents a shape having, for example, unevenness or chamfering within a range in which the same level of effect can be obtained. When the expression "comprising", "including", "provided with", "containing" or "having" one component is used, the expression is not an exclusive expression excluding the presence of other components. When the expression "at least any one of A, B, and C" is used, the expression includes only A, only B, only C, any two of A, B and C, and all of A, B and C.

### <First embodiment>

### <Overall configuration of substrate processing apparatus>

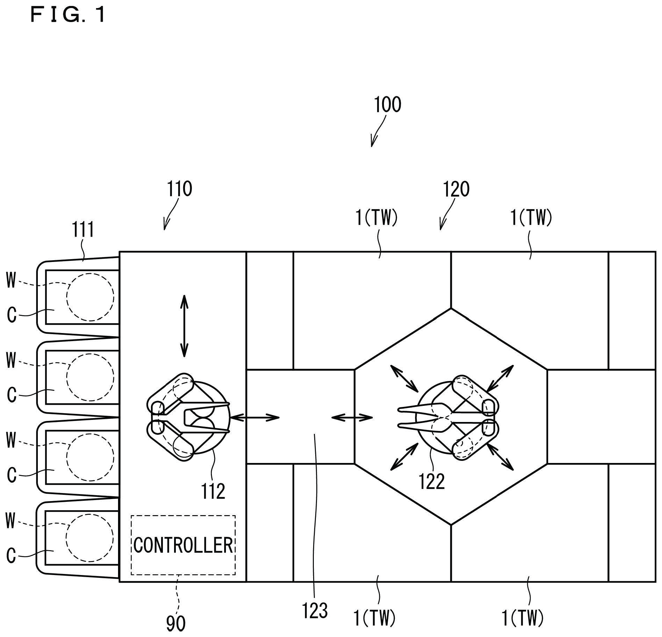

FIG. 1 is a plan view schematically illustrating an example of a configuration of a substrate processing apparatus 100. The substrate processing apparatus 100 is a sheet-fed processing apparatus that processes substrates W one by one.

The substrate W is, for example, a semiconductor wafer, a liquid crystal display substrate, an organic electroluminescence (EL) substrate, a flat panel display (FPD) substrate, an optical display substrate, a magnetic disk substrate, an optical disk substrate, a magneto-optical disk substrate, a photomask substrate, or a solar cell substrate. The substrate W has a thin flat plate shape. Hereinafter, it is assumed that the substrate W is a semiconductor wafer. The substrate W has, for example, a disk shape. The diameter of the substrate W is, for example, about 300 mm, and the thickness of the substrate W is, for example, about 0.5 mm or more and about 3 mm or less.

In the example of FIG. 1, the substrate processing apparatus 100 includes an indexer block 110, a processing block 120, and a controller 90. The processing block 120 is a portion that mainly processes the substrate W, and the indexer block 110 is a portion that mainly conveys the substrate W between the outside of the substrate processing apparatus 100 and the processing block 120.

The indexer block 110 includes a load port 111 and a first conveyance unit 112. A substrate container (hereinafter referred to as a carrier) C carried in from the outside is placed on the load port 111. For example, a plurality of substrates W are accommodated in the carrier C while being arranged at intervals in the vertical direction. In the example of FIG. 1, a plurality of load ports 111 are arranged.

The first conveyance unit 112 is a conveyance robot, and can take out an unprocessed substrate W from the carrier C placed on each load port 111. The first conveyance unit 112 may also be referred to as an indexer robot. The first conveyance unit 112 conveys the unprocessed substrate W taken out from the carrier C to the processing block 120. The processing block 120 can process the unprocessed substrate W. In addition, the first conveyance unit 112 can receive the processed substrate W from the processing block 120 and convey the processed substrate W to the carrier C of the load port 111.

In the example of FIG. 1, the processing block 120 includes a plurality of processing units 1 and a second conveyance unit 122. The second conveyance unit 122 is a conveyance robot, and can convey the substrate W between the first conveyance unit 112 and the plurality of processing units 1. In the example of FIG. 1, the processing block 120 also includes a placement part 123. The placement part 123 is, for example, a shelf on which a plurality of substrates W can be placed while being arranged in the vertical direction. The first conveyance unit 112 places the unprocessed substrate W on the placement part 123. The second conveyance unit 122 takes out the unprocessed substrate W from the placement part 123 and conveys the unprocessed substrate W to the processing unit 1. The processing unit 1 processes the substrate W. The configuration of the processing unit 1 will be described later. The second conveyance unit 122 takes out the processed substrate W from the processing unit 1 and conveys the processed substrate W to the placement part 123. The first conveyance unit 112 takes out the processed substrate W from the placement part 123 and conveys the processed substrate W to the carrier C of the load port 111.

In the example of FIG. 1, the plurality of (e.g., four) processing units 1 are provided so as to surround the second conveyance unit 122 in plan view. The second conveyance unit 122 may also be referred to as a center robot. The plurality of processing units 1 may be stacked in the vertical direction at each of their positions in plan view. That is, a plurality of (four in the drawing) towers TW formed by the plurality of processing units 1 stacked in the vertical direction may be provided so as to surround the second conveyance unit 122.

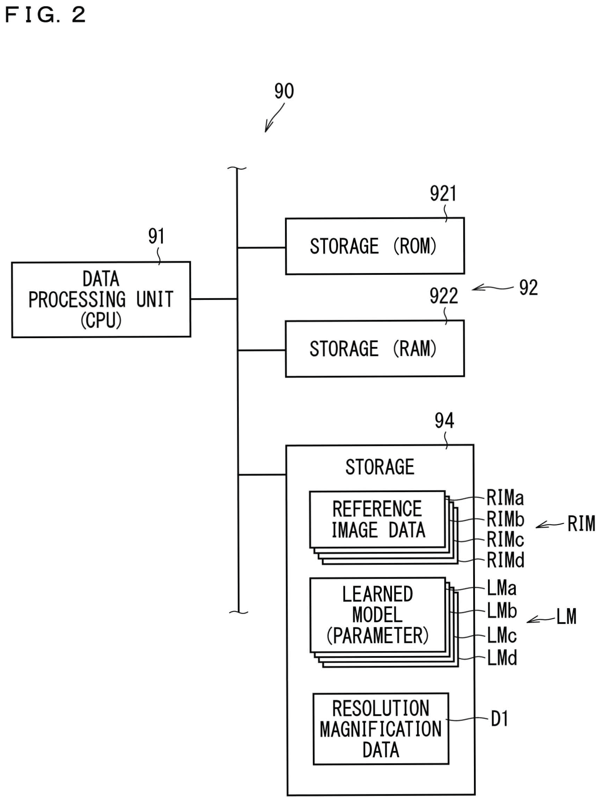

The controller 90 integrally controls the substrate processing apparatus 100. Specifically, the controller 90 controls the first conveyance unit 112, the second conveyance unit 122, and the processing unit 1. FIG. 2 is a block diagram schematically illustrating an example of a configuration of the controller 90. The controller 90 is an electronic circuit, and includes, for example, a data processing unit 91 and a storage 92. In the specific example of FIG. 2, the data processing unit 91 and the storage 92 are connected to each other via a bus. The data processing unit 91 may be, for example, an arithmetic processing apparatus such as a central processor unit (CPU). The storage 92 may include a non-transitory storage (e.g., read only memory (ROM)) 921 and transitory storage (e.g., random access memory (RAM)) 922. The non-transitory storage 921 may store, for example, a program that defines processing to be executed by the controller 90. When the data processing unit 91 executes this program, the controller 90 can execute processing defined in the program. Of course, part or all of the processing executed by the controller 90 may be executed by hardware such as a dedicated logic circuit.

As illustrated in FIG. 2, the controller 90 may be electrically connected to a storage 94. The storage 94 is a non-transitory storage, and may be, for example, a memory or a hard disk. In the example of FIG. 2, various kinds of data are stored in the storage 94. Each kind of data will be described in detail later.

### <Processing unit>

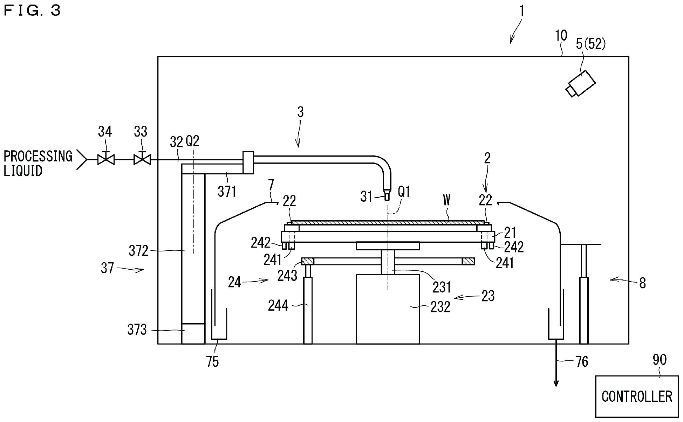

FIG. 3 is a longitudinal sectional view schematically illustrating an example of a configuration of the processing unit 1 according to the first embodiment. Note that not all the processing units 1 belonging to the substrate processing apparatus 100 need to have the configuration illustrated in FIG. 3. It is sufficient that at least one processing unit 1 has the configuration illustrated in FIG. 3.

The processing unit 1 includes a chamber 10. The chamber 10 forms a processing chamber for processing the substrate W. Specifically, the internal space of the chamber 10 corresponds to the processing chamber. The chamber 10 is provided with an openable and closable conveyance port (not illustrated). The second conveyance unit 122 carries the unprocessed substrate W into the chamber 10 through the conveyance port, and carries the processed substrate W out of the chamber 10 through the conveyance port.

In the chamber 10, various configurations used for processing the substrate W are provided. For example, the chamber 10 includes a substrate holding unit 2, a nozzle 31, and a guard 7.

The substrate holding unit 2 rotates the substrate W around a rotation axis Q1 while holding the substrate W in a horizontal attitude. The horizontal attitude here is an attitude in which the thickness direction of the substrate W is along the vertical direction. The rotation axis Q1 is an axis passing through the center of the substrate W and extending along the vertical direction. Such a substrate holding unit 2 may also be referred to as a spin chuck.

In the example of FIG. 3, the substrate holding unit 2 includes a spin base 21, a chuck pin 22, a rotation drive unit 23, and a pin drive unit 24. The spin base 21 has a plate-like shape (e.g., disk shape), and is provided in an attitude in which the thickness direction thereof is along the vertical direction. A plurality of (e.g., three or more) chuck pins 22 are provided on an upper surface of the spin base 21. The plurality of chuck pins 22 are provided at equal intervals along the circumferential direction with respect to the rotation axis Q1. The plurality of chuck pins 22 are provided so as to be displaceable between a holding position and a release position to be described below. The holding position is a position where the chuck pin 22 abuts on the peripheral edge of the substrate W. When the plurality of chuck pins 22 stop at the respective holding positions, the plurality of chuck pins 22 hold the substrate W. FIG. 3 illustrates the chuck pin 22 stopped at the holding position. The release position is a position where the chuck pin 22 is separated from the substrate W. When the plurality of chuck pins 22 stop at the respective release positions, the holding of the substrate W by the plurality of chuck pins 22 is released.

The pin drive unit 24 displaces the chuck pin 22 between the holding position and the release position. In the example of FIG. 3, the pin drive unit 24 includes a plurality of displacement magnets 241, a plurality of fixed magnets 242, a drive magnet 243, and a magnet elevation drive unit 244. The displacement magnet 241 is provided at the lower end of each chuck pin 22. The fixed magnet 242 is provided in a lower portion of the spin base 21. The drive magnet 243 has, for example, an annular shape surrounding the rotation axis Q1. The magnet elevation drive unit 244 raises and lowers the drive magnet 243 between a magnet upper position and a magnet lower position. The magnet elevation drive unit 244 includes, for example, a drive source such as a motor or an air cylinder, and is controlled by the controller 90. When the drive magnet 243 is located at the magnet upper position, the displacement magnet 241 and the chuck pin 22 integrally move to one of the holding position and the release position by the magnetic force between the displacement magnet 241 and the drive magnet 243. When the drive magnet 243 is located at the magnet lower position, the displacement magnet 241 and the chuck pin 22 integrally move to the other of the holding position and the release position by the magnetic force between the displacement magnet 241 and the fixed magnet 242.

The rotation drive unit 23 includes a shaft 231 and a motor 232. The upper end of the shaft 231 is connected to a lower surface of the spin base 21, and the shaft 231 extends from the lower surface of the spin base 21 along the rotation axis Q1. The motor 232 is controlled by the controller 90 to rotate the shaft 231 around the rotation axis Q1. As a result, the spin base 21, the chuck pin 22, and the substrate W rotate integrally around the rotation axis Q1.

The nozzle 31 discharges a processing liquid toward a main surface of the substrate W held by the substrate holding unit 2. In the example of FIG. 3, the nozzle 31 is provided vertically above the substrate W held by the substrate holding unit 2, and discharges the processing liquid toward an upper surface of the substrate W. The nozzle 31 may be a nozzle that discharges the processing liquid in a continuous flow state, or may be a mist nozzle or a spray nozzle that discharges the processing liquid in a droplet state. Here, as an example, the nozzle 31 is a nozzle that discharges the processing liquid in a continuous flow state.

The processing liquid may be a chemical liquid, a rinse liquid, or a discharging liquid. The chemical liquid may be a cleaning liquid for removing foreign substances on the substrate W or an etching liquid for removing a target film. As the chemical liquid, for example, liquids such as fluoronitric acid obtained by mixing hydrofluoric acid, nitric acid, and water, hydrofluoric acid hydrogen peroxide aqueous solution (FPM) obtained by mixing hydrofluoric acid, hydrogen peroxide, and water, tetramethylammonium hydroxide (TMAH), a mixed solution of sulfuric acid and hydrogen peroxide (SPM), ammonia water, a mixed solution of ammonia, hydrogen peroxide, and water (SC-1), and a mixed solution of hydrogen chloride, hydrogen peroxide, and water (SC-2) can be applied. Note that the chemical liquid may be a single liquid instead of a mixed liquid. For example, a single liquid such as hydrofluoric acid (HF), hydrogen peroxide water, and sulfuric acid can be applied as the chemical liquid. The rinse liquid may be pure water (i.e., deionized water) or an organic solvent such as isopropyl alcohol having higher volatility than pure water. The discharging liquid is a liquid for removing charge of the substrate W, and may be carbon dioxide water. The carbon dioxide water may be used as a rinse liquid.

In the example of FIG. 3, a downstream end of a liquid supply pipe 32 is connected to the nozzle 31. An upstream end of the liquid supply pipe 32 is connected to a processing liquid supply source. The processing liquid supply source supplies the processing liquid to the upstream end of the liquid supply pipe 32. In the example of FIG. 3, a supply valve 33 and a flow rate regulating valve 34 are interposed in the liquid supply pipe 32. The supply valve 33 switches opening and closing of the liquid supply pipe 32, and the flow rate regulating valve 34 adjusts the flow rate of the processing liquid flowing through the liquid supply pipe 32. The flow rate regulating valve 34 may be a mass flow controller. These valves are controlled by the controller 90.

In the example of FIG. 3, the processing unit 1 includes a nozzle movement drive unit 37 that moves the nozzle 31. The nozzle movement drive unit 37 moves the nozzle 31 between a processing position and a standby position described below. The processing position is a position where the nozzle 31 discharges the processing liquid toward the main surface of the substrate W held by the substrate holding unit 2, and is, for example, a position facing a central portion of the substrate W in the vertical direction. The example of FIG. 3 illustrates the nozzle 31 located at the processing position. The standby position is a position where the nozzle 31 does not discharge the processing liquid toward the main surface of the substrate W, and is, for example, a position radially outside the substrate W.

In the example of FIG. 3, the nozzle movement drive unit 37 includes an arm 371, a support column 372, and a drive source 373. The support column 372 is provided radially outside the guard 7 described later, and extends along the vertical direction. The arm 371 extends along the horizontal direction, and has a distal end connected to the nozzle 31 and a proximal end connected to the support column 372. The drive source 373 is controlled by the controller 90, and rotates the support column 372 in forward and backward directions within a predetermined angle range around a central axis Q2 thereof. The drive source 373 includes, for example, a motor. When the support column 372 rotates in forward and backward directions within a predetermined angle range around the central axis Q2, the nozzle 31 reciprocates along the circumferential direction with respect to the central axis Q2. The support column 372 is installed such that the processing position and the standby position are located on the movement trajectory of the nozzle 31. Note that the nozzle movement drive unit 37 is not necessarily limited to the mode of FIG. 3, and may include a linear motion mechanism such as a linear motor, for example.

When the processing liquid is discharged toward the main surface of the rotating substrate W in a state where the nozzle 31 is located at the processing position, the processing liquid is deposited on the main surface of the substrate W. The processing liquid receives a centrifugal force accompanying the rotation of the substrate W, flows radially outward, and scatters outside the peripheral edge of the substrate W. At this time, the processing liquid acts on the main surface of the substrate W, so that processing corresponding to the type of the processing liquid is performed on the substrate W.

The nozzle 31, the liquid supply pipe 32, the supply valve 33, and the flow rate regulating valve 34 constitute a discharge unit 3. The discharge unit 3 may have a configuration capable of sequentially discharging a plurality of types of processing liquids toward the main surface of the substrate W. For example, the discharge unit 3 can discharge the chemical liquid and the rinse liquid in this order toward the main surface of the substrate W. As a specific example, the nozzle 31 can be shared by the chemical liquid and the rinse liquid. In this case, the liquid supply pipe 32 for the chemical liquid and the liquid supply pipe 32 for the rinse liquid join and are connected to the nozzle 31. The chemical liquid supply pipe 32 is provided with the chemical liquid supply valve 33 and the flow rate regulating valve 34, and the rinse liquid supply pipe 32 is provided with the rinse liquid supply valve 33 and the flow rate regulating valve 34. Note that the chemical liquid nozzle 31 and the rinse liquid nozzle 31 may be separately provided.

The guard 7 receives the processing liquid scattered from the peripheral edge of the substrate W. The guard 7 has a tubular shape surrounding the substrate W held by the substrate holding unit 2. The guard elevation drive unit 8 raises and lowers the guard 7 between a guard processing position and a guard standby position described below. The guard processing position is a position where the upper end of the guard 7 is vertically above the upper surface of the substrate W held by the substrate holding unit 2. The example of FIG. 3 illustrates the guard 7 located in the guard processing position. In a state where the guard 7 is located at the guard processing position, the processing liquid scattered from the peripheral edge of the substrate W is received by an inner peripheral surface of the guard 7. The guard standby position is a position where the upper end of the guard 7 is vertically below the upper surface of the spin base 21. The guard elevation drive unit 8 includes, for example, a power transmission unit such as a rack-and-pinion mechanism and a ball screw mechanism, and a power source such as a motor. Alternatively, the guard elevation drive unit 8 may include an air cylinder.

In FIG. 3, a cup 75 corresponding to the guard 7 is provided. The cup 75 has a ring-shaped (e.g., annular) recess (groove) surrounding the rotation axis Q1. The cup 75 receives the processing liquid flowing down on the inner peripheral surface of the guard 7. An upstream end of a drain 76 is connected to, for example, a bottom portion of the cup 75. The processing liquid received by the cup 75 is discharged to the outside of the processing unit 1 through the drain 76.

### <Outline of example of substrate processing>

Such a processing unit 1 can process the substrate W as follows, for example. First, the second conveyance unit 122 conveys the substrate W to the processing unit 1, and the substrate holding unit 2 holds the substrate W received from the second conveyance unit 122. As a specific example, the substrate holding unit 2 displaces the plurality of chuck pins 22 from the release positions to the holding positions. As a result, the substrate holding unit 2 holds the substrate W. The substrate holding unit 2 continues to hold the substrate W until the processing on the substrate W is completed.

Next, the processing unit 1 executes chemical liquid processing. Specifically, the guard elevation drive unit 8 raises the guard 7 to the guard processing position, the nozzle movement drive unit 37 moves the nozzle 31 to the processing position, and the substrate holding unit 2 rotates the substrate W around the rotation axis Q1. The substrate holding unit 2 may continue the rotation of the substrate W until the processing of the substrate W is completed. Then, the controller 90 opens the chemical liquid supply valve 33. As a result, the chemical liquid is discharged from the nozzle 31 toward the central portion of the main surface of the rotating substrate W. The chemical liquid deposited on the main surface of the substrate W flows radially outward with the rotation of the substrate W and scatters from the peripheral edge of the substrate W. At this time, the chemical liquid acts on the main surface of the substrate W, and processing according to the type of the chemical liquid is performed on the substrate W.

When the substrate W is sufficiently processed, the processing unit 1 ends the chemical liquid processing. For example, when a predetermined chemical liquid time has elapsed from the start of chemical liquid supply, the controller 90 closes the chemical liquid supply valve 33. The time is measured by, for example, a timer circuit (not illustrated) belonging to the controller 90.

Next, the processing unit 1 executes rinse processing. Specifically, the controller 90 opens the rinse liquid supply valve 33. As a result, the rinse liquid is discharged from the nozzle 31 toward the central portion of the main surface of the rotating substrate W. The rinse liquid deposited on the main surface of the substrate W flows radially outward with the rotation of the substrate W and scatters from the peripheral edge of the substrate W. At this time, since the rinse liquid pushes away the chemical liquid on the main surface of the substrate W, the chemical liquid on the main surface of the substrate W can be replaced with the rinse liquid.

When the chemical liquid on the main surface of the substrate W is sufficiently replaced with the rinse liquid, the processing unit 1 ends the rinse processing. For example, when a predetermined rinse time has elapsed from the start of rinse liquid supply, the controller 90 closes the rinse liquid supply valve 33. Then, the nozzle movement drive unit 37 moves the nozzle 31 to the standby position.

Next, the processing unit 1 performs drying processing. Specifically, the substrate holding unit 2 increases the rotation speed of the substrate W (spin dry). When the substrate W is sufficiently dried, the processing unit 1 ends the drying processing. Specifically, when a predetermined drying time has elapsed from the start of the drying processing, the substrate holding unit 2 stops the rotation of the substrate W. As a result, the drying processing is substantially completed, and the series of processing on the substrate W is substantially completed.

Next, the guard elevation drive unit 8 lowers the guard 7 to the guard standby position, and the substrate holding unit 2 releases the holding of the substrate W. As a specific example, the substrate holding unit 2 displaces the plurality of chuck pins 22 from the respective holding positions to the release positions. As a result, the holding of the substrate W by the plurality of chuck pins 22 is released. Then, the second conveyance unit 122 lifts the processed substrate W vertically upward from the substrate holding unit 2, and takes out the substrate W from the processing unit 1.

### <Monitoring target>

As described above, the substrate W is appropriately processed by appropriately operating each component in the chamber 10. On the other hand, when each configuration cannot be appropriately operated, excess or deficiency occurs in the processing of the substrate W, or the processing of the substrate W cannot be performed.

Therefore, in the present embodiment, the processing unit 1 monitors each configuration of the chamber 10. As illustrated in FIG. 3, the processing unit 1 includes a monitoring camera 5. The camera 5 receives light from a monitoring region including at least one monitoring target among a plurality of monitoring targets in the chamber 10, and generates monitoring image data IM1. The camera 5 outputs the monitoring image data IM1 to the controller 90. The controller 90 also functions as an image processing unit that processes the monitoring image data IM1.

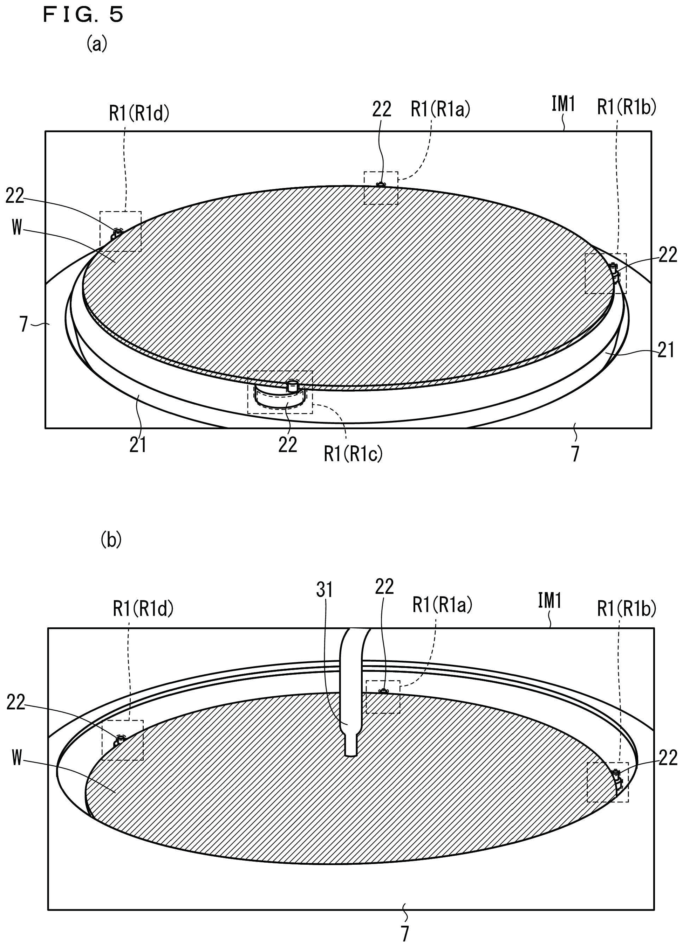

The monitoring camera 5 may be an imaging camera 52 that receives visible light. The imaging camera 52 includes, for example, a solid-state imaging element such as a charge coupled device (CCD) or a complementary metal oxide semiconductor (CMOS), and an optical system such as a lens. The monitoring image data IM1 generated by the imaging camera 52 may also be referred to as captured image data or two-dimensional image data. In the example of FIG. 3, the camera 5 is provided at a position vertically above and radially outside the substrate holding unit 2. The camera 5 is fixed to the chamber 10 through a fixing member (not illustrated). An imaging direction of the camera 5 is set on the rotation axis Q1 side and in a vertically lower oblique direction. Here, the imaging region (i.e., monitoring region) of the camera 5 can be set to include, for example, the entire upper opening of the guard 7 located at the guard processing position (see also FIG. 5(b)).

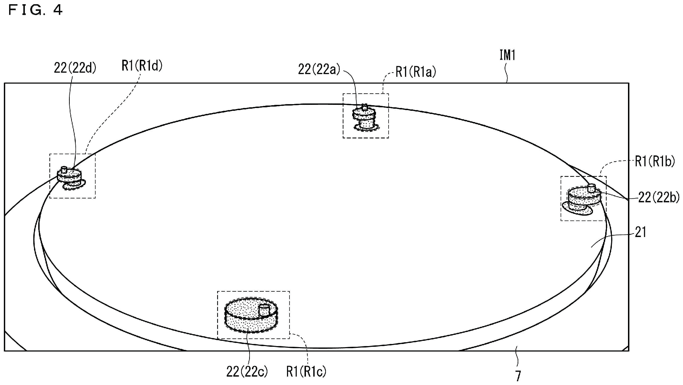

FIGS. 4 and 5 are diagrams schematically illustrating an example of the monitoring image data IM1 generated by the imaging camera 52. FIG. 4 illustrates the monitoring image data IM1 generated by imaging the monitoring region by the imaging camera 52 in the following situation. That is, the imaging camera 52 images the monitoring region in a situation where the guard 7 is located at the guard standby position and the plurality of chuck pins 22 are abutting on the release position. In the example of FIG. 4, the substrate W has not yet been carried in, and the monitoring image data IM1 includes the entirety of each of the plurality of chuck pins 22.

FIG. 5(a) illustrates the monitoring image data IM1 generated by imaging the monitoring region by the imaging camera 52 in the following situation. That is, the imaging camera 52 images the monitoring region in a situation where the guard 7 is located at the guard standby position and the plurality of chuck pins 22 abut on the peripheral edge of the substrate W. In FIG. 5(a), the substrate W is held by a plurality of chuck pins 22, and each chuck pin 22 is partially hidden by the substrate W. FIG. 5(b) illustrates the monitoring image data IM1 generated by imaging the monitoring region by the imaging camera 52 in the following situation. That is, the imaging camera 52 images the monitoring region in a situation where the guard 7 is located at the guard processing position, the plurality of chuck pins 22 abut on the peripheral edge of the substrate W, and the nozzle 31 is located at the processing position. In the example of FIG. 5(b), the lower chuck pin 22 of the monitoring image data IM1 is hidden by the guard 7.

As the monitoring target in the chamber 10, for example, various targets such as the nozzle 31, the chuck pin 22, and the guard 7 can be applied. For example, the processing unit 1 may monitor the state of the monitoring target such as the position of the nozzle 31, the state of the processing liquid discharged from the nozzle 31 (discharge state, discharge stop state, and the like), the position of the chuck pin 22, and the position of the guard 7 based on the monitoring image data IM1. Hereinafter, as a specific example of the monitoring target, a plurality of chuck pins 22 will be described as an example.

In the example of FIG. 4, the substrate holding unit 2 does not hold the substrate W, and the substrate W has not yet been carried into the chamber 10. Therefore, the monitoring image data IM1 includes all the chuck pins 22 on the spin base 21. In the example of FIG. 4, as the plurality of chuck pins 22, a chuck pin 22a (e.g., corresponding to first monitoring target), a chuck pin 22b (e.g., corresponding to second monitoring target), a chuck pin 22c, and a chuck pin 22d are provided. In the example of FIG. 4, the chuck pin 22a is located on the back side as viewed from the imaging camera 52, the chuck pin 22b is located on the right side as viewed from the imaging camera 52, the chuck pin 22c is located on the near side as viewed from the imaging camera 52, and the chuck pin 22d is located on the left side as viewed from the imaging camera 52.

For example, at the time of loading the substrate W, the second conveyance unit 122 transfers the substrate W to the substrate holding unit 2 in a state where the chuck pin 22 is located at the release position. At the time of this loading, it is not desirable that the chuck pin 22 is located at the holding position. Therefore, the processing unit 1 may monitor the position of the chuck pin 22 based on the monitoring image data IM1.

Here, in the monitoring image data IM1, the shape of the contour of the chuck pin 22 may be unclear. For example, the focus position of the lens of the imaging camera 52 may be set approximately near the center of the spin base 21. In this case, the contour of an object away from the focus position in the imaging direction is blurred in the monitoring image data IM1. That is, the shape of the contour of the object may be unclear. This is because light from one point of the object is incident across a plurality of pixels of the solid-state imaging element through the lens of the imaging camera 52. Therefore, the pixel values of the plurality of pixels are averaged, and the shape of the contour becomes unclear. That is, by this averaging, the spatial frequency of the image group representing the object in the monitoring image data IM1 becomes low, and the shape of the contour becomes unclear. In other words, the number of substantial pixels for representing the object is reduced. In the example of FIG. 4, a broken line adjacent to the contour line is added to schematically illustrate that the shape of the contour is unclear.

In the example of FIG. 4, since the chuck pin 22a and the chuck pin 22c are separated from the focus position in the imaging direction, the shapes of the contour of the chuck pin 22a and the chuck pin 22c may be more unclear than the contour shapes of the chuck pin 22b and the chuck pin 22d.

In addition, in the monitoring image data IM1, as the size of the object is smaller, the shape of the contour of the object may become unclear. This is because the smaller the size of the object in the monitoring image data IM1, the smaller the number of pixels for representing the contour of the object. In the example of FIG. 4, since the distance between the chuck pin 22a and the imaging camera 52 is longer than the distance between the other chuck pins 22 and the imaging camera 52, the chuck pin 22a is the smallest in the monitoring image data IM1. For this reason, the shape of the contour of the chuck pin 22a may be unclear as compared with the shapes of the contours of the other chuck pins 22. For example, the shape of the contour of the chuck pin 22a may be more unclear than the shape of the contour of the chuck pin 22c.

As described above, the clarity of the shape of the contour of the chuck pin 22 in the monitoring image data IM1 may be different among the chuck pin 22a to the chuck pin 22d. When an object is monitored using the monitoring image data IM1 including the object having such an unclear contour, the monitoring accuracy may be deteriorated.

Therefore, the controller 90 generates high-resolution image data IM2 obtained by enhancing the resolution of the monitoring image data IM1 using a learned model LM of resolution enhancement processing. The controller 90 monitors the monitoring target based on the high-resolution image data IM2.

In the example of FIG. 2, the storage 94 stores a plurality of learned models LM respectively corresponding to a plurality of monitoring targets. More specifically, the storage 94 stores parameters used in the learned model LM. Here, as the plurality of learned models LM, a learned model LMa (e.g., corresponding to first learned model) corresponding to the chuck pin 22a, a learned model LMb (e.g., corresponding to a second learned model) corresponding to the chuck pin 22b, a learned model LMc corresponding to the chuck pin 22c, and a learned model LMd corresponding to the chuck pin 22d are stored in the storage 94.

Each learned model LM is generated based on learning image data including a corresponding monitoring target. That is, the learned model LMa is generated based on the learning image data including the chuck pin 22a, the learned model LMb is generated based on the learning image data including the chuck pin 22b, the learned model LMc is generated based on the learning image data including the chuck pin 22c, and the learned model LMd is generated based on the learning image data including the chuck pin 22d. The generation method will be described later.

In addition, in the example of FIG. 2, resolution-corresponding data D1 is stored in the storage 94. Table 1 is a table illustrating the resolution-corresponding data D1.

**[Table 1]**

| monitoring target | resolution magnification RM |
|---|---|
| chuck pin 22a | RMa |
| chuck pin 22b | RMb |
| chuck pin 22c | RMc |
| chuck pin 22d | RMd |

As shown in Table 1, the resolution-corresponding data D1 indicates a plurality of resolution magnifications RM respectively corresponding to a plurality of monitoring targets. In Table 1, a resolution magnification RMa (e.g., corresponding to first resolution magnification) corresponding to the chuck pin 22a is set, a resolution magnification RMb (e.g., corresponding to second resolution magnification) corresponding to the chuck pin 22b is set, a resolution magnification RMc corresponding to the chuck pin 22c is set, and a resolution magnification RMd corresponding to the chuck pin 22d is set. Each resolution magnification RM is set in advance, for example, such that the clarity of the contour of each monitoring target (chuck pin 22) becomes equal to or more than a value sufficient for monitoring. The resolution magnification RM can be set by experiment or simulation.

The controller 90 generates the high-resolution image data IM2 obtained by enhancing the resolution of the monitoring image data IM1 using the learned model LM corresponding to the monitoring target. At this time, the controller 90 enhances the resolution of the monitoring image data IM1 at the resolution magnification RM corresponding to the monitoring target. Specifically, the controller 90 inputs the monitoring image data IM1 and the resolution magnification RM to the learned model LM, and generates the high-resolution image data IM2 by the resolution enhancement processing by the learned model LM.

The resolution enhancement processing by the learned model LM may be, for example, processing using a super-resolution technology. For example, the learned model LM is a learned model using deep learning, and as a specific example, may be a learned model by VDSR, a learned model by ResNet, a learned model by SRResNet, or a learned model by an architecture (Bee Lim, et. al., "Enhanced Deep Residual Networks for Single Image Super-Resolution", Department of ECE, ASRIM, Seoul National University, 08826, Seoul, Korea, arXiv: 1707.02921v1 [cs.CV] 10 Jul 2017) in which a batch normalization layer is deleted from SRResNet.

In addition, the controller 90 monitors each monitoring target based on the high-resolution image data IM2. For example, the controller 90 monitors the position of each chuck pin 22 based on the high-resolution image data IM2.

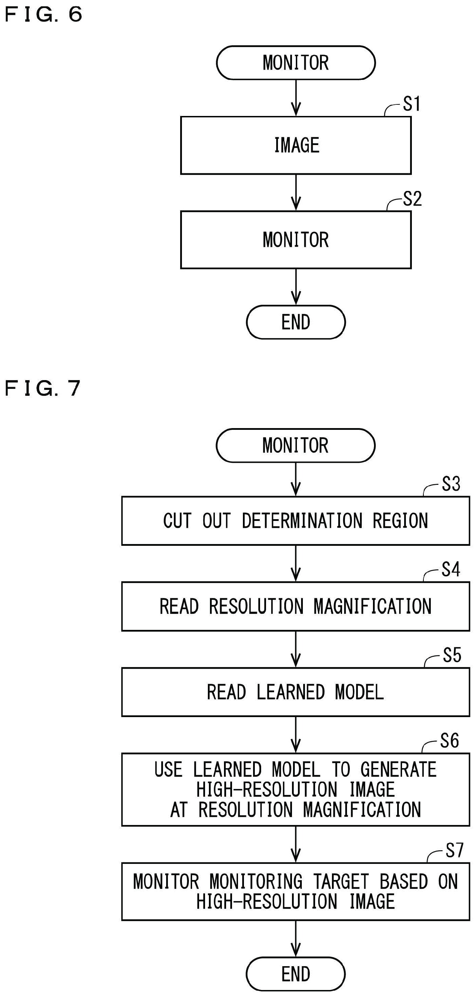

FIG. 6 is a flowchart illustrating an example of a monitoring method by the processing unit 1. First, the imaging camera 52 images a monitoring region and generates the monitoring image data IM1 (step S1: image generation process). The imaging camera 52 outputs the monitoring image data IM1 to the controller 90. Here, as an example, the imaging camera 52 can image the monitoring region immediately before the second conveyance unit 122 carries the substrate W into the processing unit 1. Immediately before the substrate W is carried in by the second conveyance unit 122, the controller 90 controls the pin drive unit 24 to stop the chuck pin 22 at the release position. Therefore, if no abnormality occurs, the chuck pin 22 is normally located at the release position. That is, the monitoring image data IM1 illustrated in FIG. 4 is generated. On the other hand, if an abnormality has occurred in the substrate holding unit 2, the chuck pin 22 can be located at a position separated from the release position by an allowable distance or more.

Note that when the substrate holding unit 2 holds the substrate W received from the second conveyance unit 122, the imaging camera 52 may image the monitoring region. In this case, if the chuck pin 22 normally moves to the holding position and the substrate holding unit 2 normally holds the substrate W, the monitoring image data IM1 illustrated in FIG. 5(a) is generated.

Next, the controller 90 monitors the monitoring target (e.g., chuck pin 22) based on the monitoring image data IM1 (step S2: monitoring process). For example, the controller 90 may determine whether or not each chuck pin 22 is located at the release position based on the monitoring image data IM1 of FIG. 4, or may determine whether or not each chuck pin 22 is located at the holding position based on the monitoring image data IM1 of FIG. 5(a).

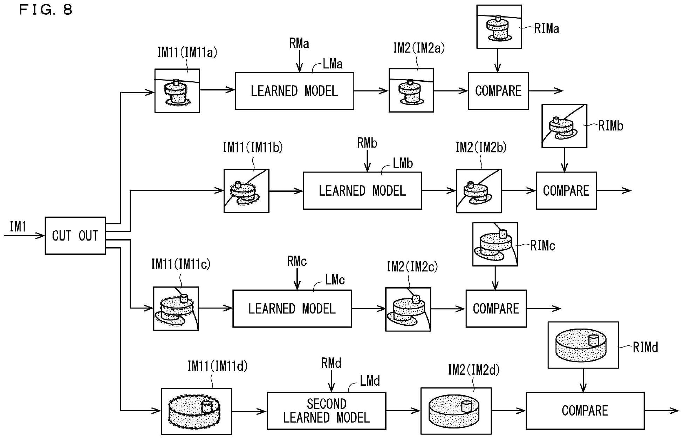

FIG. 7 is a flowchart illustrating a specific example of the monitoring process, and FIG. 8 is a diagram illustrating an example of a flow of each piece of data in the monitoring process. In the example of FIG. 7, first, the controller 90 cuts out a plurality of determination regions R1 respectively including a plurality of monitoring targets (e.g., chuck pins 22) from the monitoring image data IM1 to generate a plurality of determination image data IM11 (step S3: cut-out process). The determination image data IM11 is a part of the monitoring image data IM1. Each determination region R1 can be set so as not to include a monitoring target different from the corresponding monitoring target.

In the example of FIGS. 4 and 5(a), determination regions R1a to R1d are illustrated as the plurality of determination regions R1. The determination regions R1a (e.g., corresponding to first determination region) to R1d are regions corresponding to the chuck pins 22a to 22d, respectively. The determination region R1 includes at least a part of the corresponding chuck pin 22 and does not include the other chuck pins 22. For example, the determination region R1a includes at least a part of the chuck pin 22a, and does not include any of the chuck pins 22b to 22d. In the example of FIG. 4, the determination region R1a is set to include the entire chuck pin 22a on the spin base 21. The determination regions R1b (e.g., corresponding to second determination region) to R1d are similarly set. The determination region R1 has, for example, a rectangular shape.

Hereinafter, the determination image data IM11 obtained by cutting out the determination region R1a from the monitoring image data IM1 is referred to as determination image data IM11a. The determination image data IM11 corresponding to the determination regions R1b to R1d is referred to as determination image data IM11b to determination image data IM11d, respectively. Note that FIG. 8 illustrates a flow of processing for the monitoring image data IM1 of FIG. 4.

Next, the controller 90 determines the resolution magnification RM corresponding to each monitoring target (step S4: resolution determination process). Specifically, the controller 90 reads the resolution-corresponding data D1 from the storage 94, and reads the resolution magnifications RMa to RMd respectively corresponding to the chuck pins 22a to 22d included in the resolution-corresponding data D1.

Next, the controller 90 determines the learned model LM corresponding to each monitoring target (step S5: learned model determination process). Specifically, the controller 90 reads the parameters of the learned models LMa to LMd respectively corresponding to the chuck pins 22a to 22d from the storage 94.

Next, the controller 90 inputs each determination image data IM11 and the corresponding resolution magnification RM to the corresponding learned model LM, and generates high-resolution image data IM2 according to the algorithm of the learned model LM (step S6: resolution enhancement process). For example, the controller 90 inputs the determination image data IM11a and the resolution magnification RMa to the learned model LMa, and generates high-resolution image data IM2a (e.g., corresponding to first high-resolution image data). Similarly, the controller 90 inputs the determination image data IM11b and the resolution magnification RMb to the learned model LMb to generate high-resolution image data IM2b (e.g., corresponding to second high-resolution image data), inputs the determination image data IM11c and the resolution magnification RMc to the learned model LMc to generate high-resolution image data IM2c, and inputs the determination image data IM11d and the resolution magnification RMd to the learned model LMd to generate high-resolution image data IM2d.

Next, the controller 90 monitors the monitoring target based on the high-resolution image data IM2 (step S7). That is, the controller 90 monitors the chuck pin 22a based on the high-resolution image data IM2a, monitors the chuck pin 22b based on the high-resolution image data IM2b, monitors the chuck pin 22c based on the high-resolution image data IM2c, and monitors the chuck pin 22d based on the high-resolution image data IM2d.

As a specific example, the controller 90 monitors the monitoring target based on comparison between the high-resolution image data IM2 and reference image data RIM stored in the storage 94. The reference image data RIM is, for example, an image including a normal monitoring target, and can be stored in the storage 94 in advance. The reference image data RIM is set for each monitoring target. For example, as the reference image data RIM, reference image data RIMa to RIMd respectively corresponding to the chuck pins 22a to 22d are stored in the storage 94. The reference image data RIMa is, for example, an image including a normal chuck pin 22a. In the example of FIG. 8, the reference image data RIMa includes the chuck pin 22a located at the release position. Similarly, the reference image data RIMb includes a normal chuck pin 22b, the reference image data RIMc includes a normal chuck pin 22c, and the reference image data RIMd includes a normal chuck pin 22d.

The position, shape and size of the reference image data RIM in the monitoring region are the same as those of the corresponding determination region R1. For example, the position, shape, and size of the reference image data RIMa in the monitoring region are the same as those in the determination region R1a. In addition, the clarity of the outline of the monitoring target in the reference image data RIM is higher than the clarity of the outline of the monitoring target in the monitoring image data IM1, and is similar to the clarity of the monitoring target in the high-resolution image data IM2. A method for generating the reference image data RIM will be described in detail later.

When the chuck pin 22a is normally located at the release position, the high-resolution image data IM2a substantially matches the reference image data RIMa. On the other hand, when the chuck pin 22a is not located at the release position due to an abnormality or the like, the high-resolution image data IM2a is not similar to the reference image data RIMa. Conversely, when the high-resolution image data IM2a is similar to the reference image data RIMa, it can be determined that the chuck pin 22a is normally located at the release position, and when the high-resolution image data IM2a is not similar to the reference image data RIMa, it can be determined that the chuck pin 22a is located at a position different from the release position. The same applies to the chuck pins 22b to 22d.

Note that in the example of FIG. 5(a), in the monitoring image data IM1, the chuck pins 22a to 22d are located so as to normally stop at the holding position. In this case, the reference image data RIMa to RIMd include images similar to the determination regions R1a to R1d in FIG. 5(a), respectively. However, the clarity of the contour of the monitoring target in the reference image data RIMa to RIMd is similar to the clarity of the contour of the monitoring target in the high-resolution image data IM2. In this case, when the high-resolution image data IM2a is similar to the reference image data RIMa, it can be determined that the chuck pin 22a is normally located at the holding position, and when the high-resolution image data IM2a is not similar to the reference image data RIMa, it can be determined that the chuck pin 22a is located at a position different from the holding position. The same applies to the chuck pins 22b to 22d.

Therefore, the controller 90 compares the high-resolution image data IM2 with the corresponding reference image data RIM for each chuck pin 22, and determines the state of the chuck pin 22 based on the comparison result. As a specific example, the controller 90 calculates the degree of similarity between the high-resolution image data IM2 and the reference image data RIM. The degree of similarity is not particularly limited, and may be, for example, a known degree of similarity such as a sum of squared differences of pixel values, a sum of absolute differences of pixel values, normalized cross-correlation, or zero-mean normalized cross-correlation.

The controller 90 determines, for each of the chuck pins 22, whether or not the degree of similarity is equal to or greater than a predetermined threshold. The threshold is a threshold for determining the presence or absence of abnormality, and is set in advance by, for example, simulation or experiment and stored in the storage 94. The controller 90 determines that the chuck pin 22 is located at a normal position when the similarity is equal to or greater than the threshold, and determines that the chuck pin 22 is located at a position different from the normal position when the similarity is less than the threshold. When the degree of similarity is less than the threshold, the controller 90 may determine that an abnormality has occurred in the chuck pin 22. When determining that an abnormality has occurred, the controller 90 may interrupt the processing.

As described above, in the present embodiment, the learned model LM corresponding to each of the plurality of monitoring targets is stored in the storage 94. Then, the controller 90 generates the high-resolution image data IM2 by performing resolution enhancement processing on the monitoring image data IM1 (specifically, determination image data IM11) using the learned model LM corresponding to the monitoring target. Since the learned model LM can more appropriately clarify the contour of the corresponding monitoring target, the contour of the monitoring target becomes clear in the high-resolution image data IM2. For example, a peak signal to noise ratio (PSNR) of the high-resolution image data IM2 is 23 or more, and a structural similarity (SSIM) of the high-resolution image data IM2 is 0.75 or more.

Therefore, the controller 90 can monitor the monitoring target with higher accuracy based on the high-resolution image data IM2. In other words, the controller 90 can determine the state of the monitoring target (position of chuck pin 22 in this case) with higher accuracy.

In addition, it is not necessary to apply an expensive imaging camera having a high resolution as the imaging camera 52. Therefore, the manufacturing cost of the substrate processing apparatus 100 can be reduced.

### <First generation method of learned model>

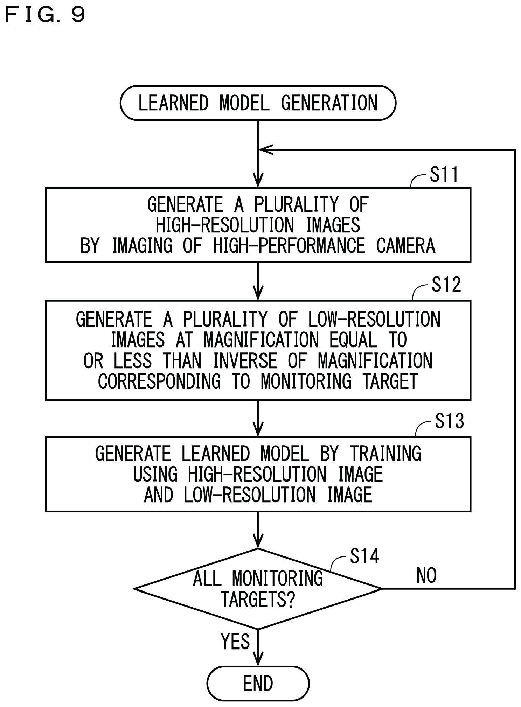

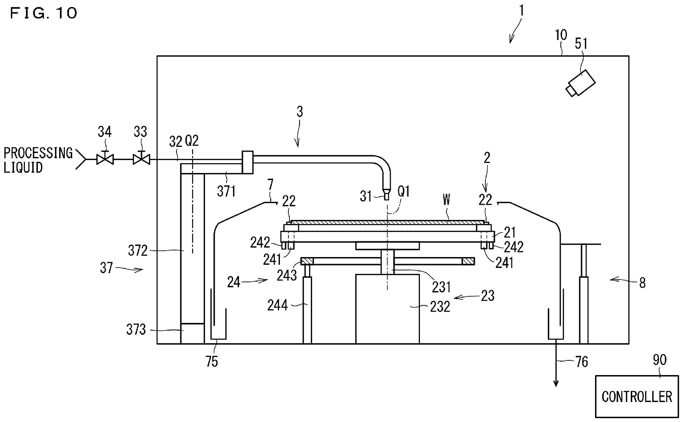

Next, a method of generating the learned model LM will be described. The training process of generating the learned model LM is executed before the image generation process (step S1). Specifically, the generation of the learned model LM is executed before the substrate processing apparatus 100 performs processing on the substrate W. FIG. 9 is a flowchart illustrating an example of a specific operation of the training process. First, the high-performance camera 51 images the monitoring region (step S11: learning image generation process). FIG. 10 is a diagram schematically illustrating an example of a state in which the high-performance camera 51 is provided in the chamber 10. The high-performance camera 51 may be installed instead of the imaging camera 52 by an operator. That is, the high-performance camera 51 may be attached to the same position as the imaging camera 52.

The high-performance camera 51 can generate captured image data having a resolution higher than the resolution of the imaging camera 52. For example, the number of pixels of the high-performance camera 51 may be larger than the number of pixels of the imaging camera 52. Furthermore, the lens inside the high-performance camera 51 is provided to be movable in the optical axis direction. That is, the high-performance camera 51 has an optical zoom function and a focus adjustment function. On the other hand, the imaging camera 52 need not have an optical zoom function, and need not have an optical focus adjustment function. In other words, the focus position of the imaging camera 52 may be fixed. Such an imaging camera 52 is inexpensive.

The imaging region of the high-performance camera 51 may be the same as the imaging region of the imaging camera 52. The imaging region of the high-performance camera 51 also includes a monitoring target (chuck pin 22 in this case). The imaging region of the high-performance camera 51 may include a plurality of chuck pins 22.

For example, the high-performance camera 51 first images the monitoring region while focusing on the chuck pin 22a. That is, the high-performance camera 51 images the monitoring region in a state where the chuck pin 22a is more in focus than at least one (e.g., chuck pin 22d) of the other monitoring targets. The shape of the contour of the chuck pin 22a in the captured image data generated by the imaging of the high-performance camera 51 is clear, the PSNR of the captured image data is 23 or more, and the SSIM of the captured image data is 0.75 or more. Hereinafter, the captured image data generated by the high-performance camera 51 is also referred to as high-resolution learning data IM3. In addition, the high-resolution learning data IM3 captured in focus on the chuck pin 22a is referred to as high-resolution learning data IM3a.

The high-performance camera 51 may image the monitoring region at a plurality of timings to generate a plurality of pieces of high-resolution learning data IM3a. For example, the high-performance camera 51 may generate the high-resolution learning data IM3a by imaging the monitoring region in situations where the states of the chuck pins 22a are different from each other. As a specific example, the high-performance camera 51 may image the monitoring region in a situation where the chuck pin 22a is located at the release position (see FIG. 4, for example), and may image the monitoring region in a situation where the chuck pin 22a is located at the holding position (see FIG. 5(a), for example). Note that a situation where the chuck pin 22a is located at the holding position can be achieved by the substrate holding unit 2 holding the substrate W.

The high-performance camera 51 is not limited to the above, and may generate the high-resolution learning data IM3 by imaging the monitoring region in a situation where the monitoring target takes various other states (e.g., abnormal state). For example, the high-performance camera 51 may image the monitoring region in a situation where the chuck pin 22 is stopped at an intermediate position between the holding position and the release position.

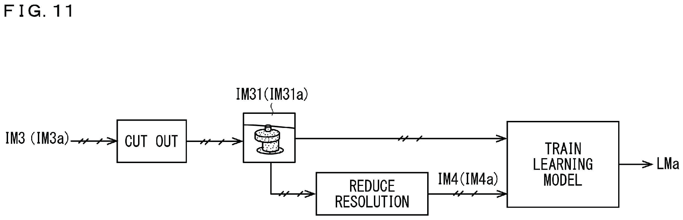

FIG. 11 is a diagram schematically illustrating a flow of data in generation of a learned model. As illustrated in FIG. 11, the controller 90 may cut out a region including the chuck pin 22a from the high-resolution learning data IM3a generated by the high-performance camera 51 to generate the high-resolution learning data IM31a. The region is, for example, the same region as the determination region R1a. The PSNR of the high-resolution learning data IM31a may be 23 or more, and the SSIM of the high-resolution learning data IM31a may be 0.75 or more.

Next, the controller 90 down-samples the plurality of pieces of high-resolution learning data IM3 at magnifications equal to or less than the inverse of the corresponding resolution magnification RM, and converts each of the plurality of pieces of high-resolution learning data IM3 into a plurality of pieces of low-resolution learning data IM4 (step S12: resolution reducing process). For example, the controller 90 down-samples the plurality of pieces of high-resolution learning data IM31 a at a magnification that is equal to or less than the inverse of the resolution magnification RMa, and converts each piece of the high-resolution learning data IM31a into a plurality of pieces of low-resolution learning data IM4a. Although the downsampling method is not particularly limited, for example, bicubic downsampling may be applied.

Next, the controller 90 trains the learning model using a plurality of sets of the high-resolution learning data IM3a (e.g., high-resolution learning data IM31a) and the low-resolution learning data IM4a, and generates the learned model LMa corresponding to the chuck pin 22a (step S13: model generation process). Specifically, the controller 90 obtains parameters of the learned model LMa corresponding to the chuck pin 22a. Then, the controller 90 stores the learned model LMa (parameter) in the storage 94.

Next, the controller 90 determines whether or not the learned models LM corresponding to all the monitoring targets have been generated (step S14). If not all the learned models LM have been generated yet, the controller 90 executes steps S11 to S13 for the next monitoring target (e.g., chuck pin 22b). For example, the high-performance camera 51 images the monitoring region in focus on the chuck pin 22b to generate the high-resolution learning data IM3 (step S11), and the controller 90 cuts out the same region as the determination region R1b including the chuck pin from the high-resolution learning data IM3 to generate the high-resolution learning data IM31, down-samples the high-resolution learning data IM31 at a magnification equal to or less than the inverse of the resolution magnification RMb to generate the low-resolution learning data IM4 (step S12), and trains the learning model using the high-resolution learning data IM31 and the low-resolution learning data IM4 corresponding to the chuck pin 22b to generate the learned model LMb (step S13). The same applies to the chuck pin 22c and the chuck pin 22d.

When it is determined in step S14 that all the learned models LM have been generated, the controller 90 ends the processing. Then, the operator appropriately removes the high-performance camera 51 from the inside of the chamber 10, and attaches the imaging camera 52 to the inside of the chamber 10.

As described above, the controller 90 generates the learned model LM based on a set of the high-resolution learning data IM3 that does not include another monitoring target and clearly includes the monitoring target and the low-resolution learning data IM4 generated from the high-resolution learning data IM3. Therefore, the controller 90 can generate the learned model LM suitable for the monitoring target. Accordingly, the controller 90 can enhance the resolution of the monitoring image data IM1 including the monitoring target with higher accuracy using the learned model LM corresponding to the monitoring target.

Furthermore, in the above-described example, the high-performance camera 51 images the same monitoring region as the imaging camera 52. Therefore, the optical characteristics of the lens group of the high-performance camera 51 through which light is transmitted at the time of imaging are similar to the optical characteristics of the lens group of the imaging camera 52 through which light is transmitted at the time of imaging. Therefore, the high-resolution learning data IM3 by the high-performance camera 51 can be made more equivalent to the high-resolution image data obtained by enhancing the resolution of the monitoring image data IM1 by the imaging camera 52. Accordingly, the controller 90 can enhance the resolution of the monitoring image data IM1 with higher accuracy using the learned model LM.

In addition, the high-performance camera 51 images the chuck pin 22a at a plurality of timings at which the displaceable chuck pin 22a is located at positions different from each other, and generates a plurality of pieces of high-resolution learning data IM3a. Specifically, the high-performance camera 51 images the monitoring region at each of the timing when the chuck pin 22a is located at the release position and the timing when the chuck pin 22a is located at the holding position. Then, the learned model LMa is generated using the plurality of pieces of high-resolution learning data IM3. According to this operation, the controller 90 can enhance the resolution of the monitoring image data IM1 with higher accuracy regardless of the state (position in this case) of the chuck pin 22a in the image generation process (step S1).

### <Reference image data>

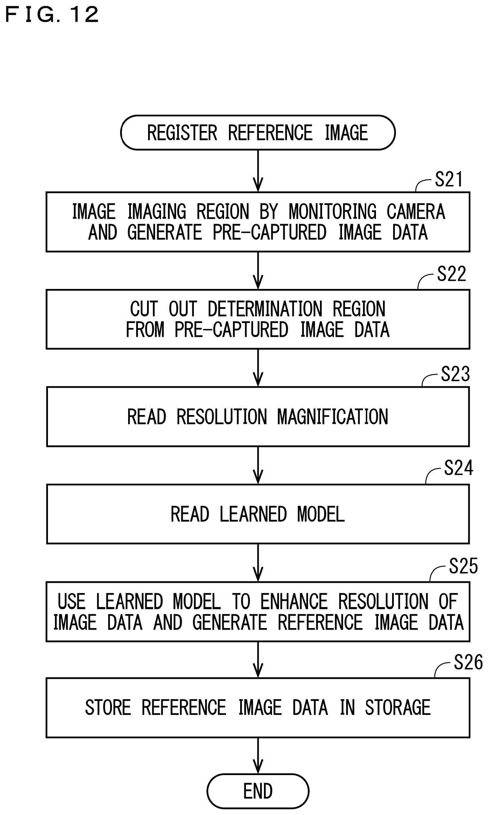

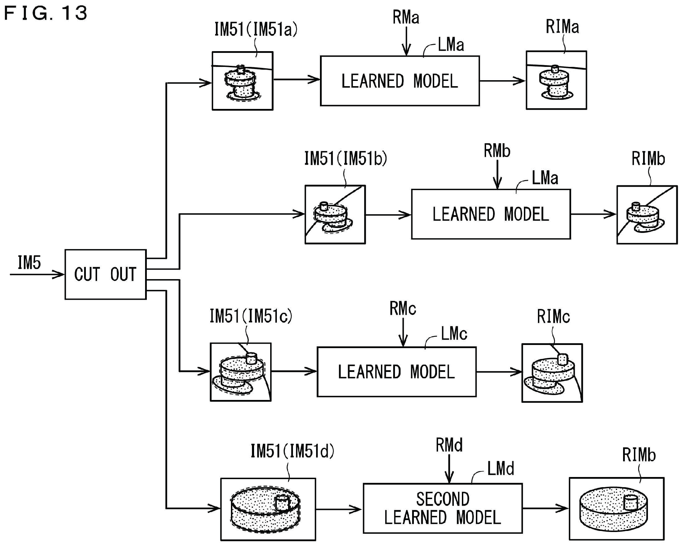

Next, a generation method for generating the reference image data RIM will be described. A reference image registration process of generating the reference image data RIM and storing the reference image data RIM in the storage 94 is executed before the image generation process (step S1). The reference image registration process is executed after the training process. That is, the reference image registration process is performed after the learned model LM is generated. Specifically, the reference image registration process can be performed before the substrate processing apparatus 100 performs processing on the substrate W, such as when the substrate processing apparatus 100 is installed. FIG. 12 is a flowchart illustrating an example of a specific operation of the reference image registration process. FIG. 13 is a diagram illustrating an example of a flow of each piece of data. Here, as an example, the processing unit 1 generates the reference image data RIM corresponding to the monitoring image data IM1 of FIG. 4.

First, the imaging camera 52 images the monitoring region and generates pre-image data IM5 (step S21: pre-image generation process). For example, the imaging camera 52 images the monitoring region in a situation where the substrate W is not carried in and the chuck pin 22 is normally located at the release position. Therefore, the pre-image data IM5 includes the chuck pin 22 normally located at the release position.

Note that the processing unit 1 may generate the reference image data RIM corresponding to the monitoring image data IM1 of FIG. 5(a). In this case, the imaging camera 52 images the monitoring region in a situation where the substrate holding unit 2 normally holds the substrate W. In this case, the pre-image data IM5 includes the chuck pin 22 normally located at the holding position.

Next, the controller 90 cuts out the determination region R1 for each monitoring target in the pre-image data IM5 to generate pre-image data IM51 (step S22: cut-out process). Specifically, the controller 90 cuts out a determination region R1a from the pre-image data IM5 to generate pre-image data IM51a. The pre-image data IM51a includes the chuck pin 22a in a normal state. In the example of FIG. 13, the pre-image data IM51a includes the chuck pin 22a located at the release position. In addition, the controller 90 cuts out determination regions R1b to R1d from the pre-image data IM5, and generates pre-image data IM51b to IM51d.

Next, the controller 90 determines the resolution magnification RM corresponding to each monitoring target (step S23: resolution determination process). Specifically, the controller 90 reads the resolution-corresponding data D1 from the storage 94, and reads the resolution magnifications RMa to RMd respectively corresponding to the chuck pins 22a to 22d included in the resolution-corresponding data D1.

Next, the controller 90 determines a learned model LM corresponding to each monitoring target (step S24: learned model determination process). Specifically, the controller 90 reads the parameters of the learned models LMa to LMd respectively corresponding to the chuck pins 22a to 22d from the storage 94.

Next, the controller 90 inputs each piece of the pre-image data IM51 and the corresponding resolution magnification RM to the corresponding learned model LM, and generates the reference image data RIM by enhancing the resolution of the pre-image data IM51 according to the algorithm of the learned model LM (step S25: reference image generation process). For example, the controller 90 inputs the pre-image data IM51a and the resolution magnification RMa to the learned model LMa, and generates the reference image data RIMa. Similarly, the controller 90 generates reference image data RIMb to RIMd.

Next, the controller 90 stores the reference image data RIMa and the reference image data RIMd in the storage 94 (step S26: storage process).

As described above, in the above-described example, the imaging camera 52 images the monitoring region and generates the pre-image data IM5 (step S21). According to this operation, the position and size of the chuck pin 22a in the monitoring image data IM1 captured in the image generation process (step S1) can be made equal to the position and size of the chuck pin 22a in the pre-image data IM5. Therefore, it is possible to further increase the degree of similarity between the determination image data IM11a including the normal chuck pin 22a and the reference image data RIMa including the normal chuck pin 22a. Therefore, the controller 90 can perform the position determination of the chuck pin 22a based on the degree of similarity between the determination image data IM11a and the reference image data RIMa with higher accuracy. The same applies to the chuck pins 22b to 22d.

In the above example, the controller 90 generates the reference image data RIMa using the learned model LMa used for generating the determination image data IM11a. That is, the determination image data IM11a and the reference image data RIMa are generated by the same algorithm. Therefore, it is possible to further increase the degree of similarity between the determination image data IM11a including the normal chuck pin 22a and the reference image data RIMa including the normal chuck pin 22a. Accordingly, the controller 90 can perform the position determination of the chuck pin 22a based on the degree of similarity between the determination image data IM11a and the reference image data RIMa with higher accuracy. The same applies to the chuck pins 22b to 22d.

In the specific example described above, the controller 90 generates the learned model LM for each monitoring target. However, the present embodiment is not necessarily limited thereto. The controller 90 may generate one learned model LM and store the learned model LM in the storage 94. That is, the controller 90 may generate one learned model LM common to a plurality of monitoring targets. Then, for example, the controller 90 may enhance the resolution of the monitoring image data IM1 including the plurality of chuck pins 22 with the learned model LM to generate the high-resolution image data IM2, and monitor each chuck pin 22 based on each determination region R1 in the high-resolution image data IM2.

### <Second generation method of learned model>

In the above example, the controller 90 generates the learned model LM based on the high-resolution learning data IM3 generated by the high-performance camera 51 and the low-resolution learning data IM4. However, the present embodiment is not necessarily limited thereto. As described later, the controller 90 may generate the learned model LM based on learning data generated by simulation. Hereinafter, for the sake of simplicity, a case where the learned model LM common to a plurality of monitoring targets is generated will be described.

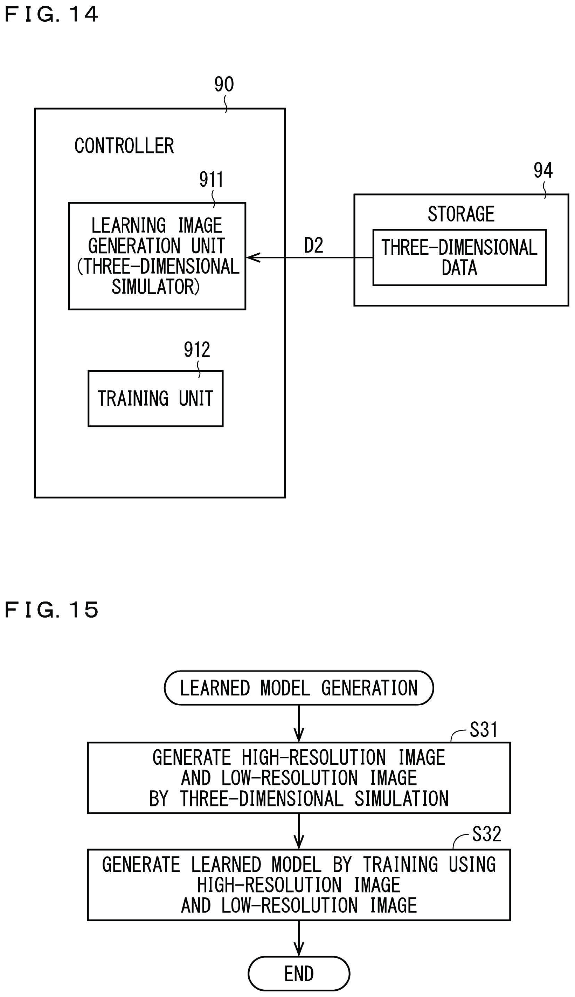

FIG. 14 is a functional block diagram illustrating an example of an internal configuration of the controller 90. The controller 90 includes a learning image generation unit 911 and a training unit 912. Three-dimensional data D2 is input to the learning image generation unit 911. As illustrated in FIG. 14, the three-dimensional data D2 can be stored in the storage 94. The three-dimensional data D2 includes geometric information about the shape of each configuration in the chamber 10 of the processing unit 1. The three-dimensional data D2 may also be referred to as a three-dimensional model. The substrate holding unit 2, the nozzle 31, the nozzle movement drive unit 37, and the guard 7 are applied to each configuration in the chamber 10. In other words, the three-dimensional data D2 is three-dimensional data obtained by modeling the monitoring target in the chamber 10. The data format of the three-dimensional data D2 may be any three-dimensional data format such as computer-aided design (CAD) data. Furthermore, the three-dimensional data D2 may further include information of at least one of a material and a surface state (e.g., pattern) of each configuration in the chamber 10. Hereinafter, a space in the chamber 10 indicated by the three-dimensional data D2 is referred to as a virtual internal space.

The learning image generation unit 911 generates simulation image data obtained by imaging the virtual internal space by a virtual camera virtually arranged in the virtual internal space. The learning image generation unit 911 is a three-dimensional simulator, and may be, for example, a functional unit based on a 3 dimension computer graphics (DCG) program such as Blender. For example, a 3DCG program is stored in a storage 921 (or storage 94), and the data processing unit 91 reads and executes the program, whereby the controller 90 implements the function of the learning image generation unit 911.

For example, the learning image generation unit 911 can have a function of three-dimensional rendering. Algorithms such as rasterization, ray tracing, and radiosity can be applied to the three-dimensional rendering. For example, if any one of ray tracing and radiosity is applied, the learning image generation unit 911 generates simulation image data obtained by imaging the virtual internal space illuminated by the virtual lighting apparatus with the virtual camera. Specifically, the learning image generation unit 911 generates the simulation image data based on information on the virtual lighting apparatus and information on the virtual camera. The information on the virtual illumination apparatus can include, for example, information on the type of the virtual lighting apparatus such as a point light source, sunlight, and spot illumination, the light amount and position of the illumination light, and the like. The information on the virtual camera can include, for example, optical information such as a focal point of a lens, and information such as the number of pixels and a position. Here, the controller 90 uses the simulation image data generated by the learning image generation unit 911 as learning data.

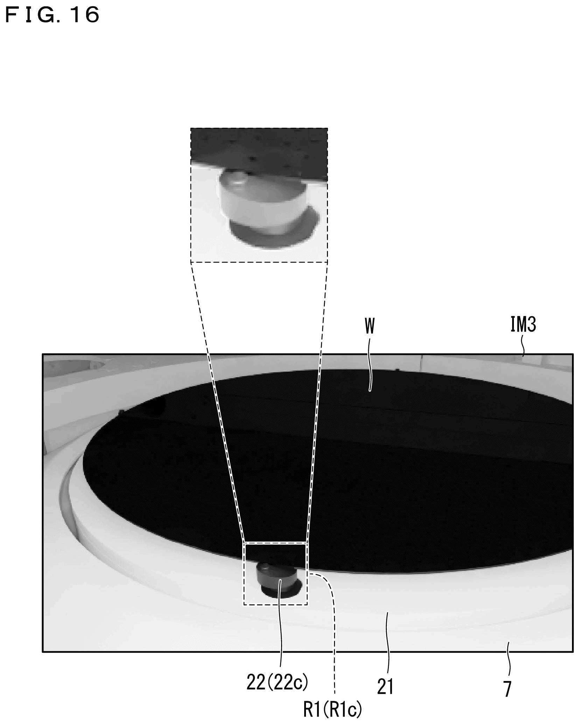

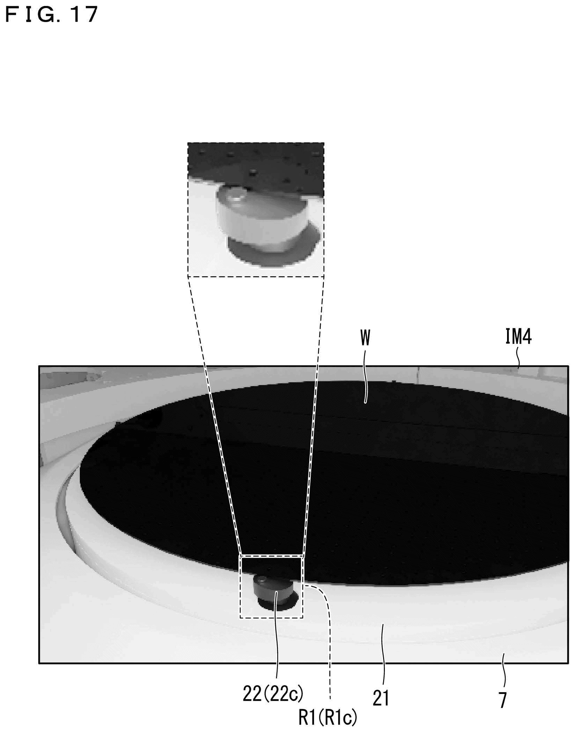

FIG. 15 is a flowchart illustrating a second example of the specific operation of the training process. In the example of FIG. 15, the learning image generation unit 911 generates simulation image data with high resolution and simulation image data with low resolution as high-resolution learning data IM3 and low-resolution learning data IM4, respectively, by three-dimensional simulation (step S31: learning image generation process). FIG. 16 is a diagram schematically illustrating an example of the high-resolution learning data IM3, and FIG. 17 is a diagram schematically illustrating an example of the low-resolution learning data IM4.

Specifically, the learning image generation unit 911 generates the high-resolution learning data IM3 obtained by imaging the virtual internal space from a predetermined position by the virtual camera with high first resolution. Similarly to real space, for example, the position of the virtual camera can be set above the substrate holding unit 2 and radially outside the guard 7 in the virtual internal space. More specifically, the position of the virtual camera may be set at a position where the entire upper opening of the guard 7 in the virtual internal space is included in the high-resolution learning data IM3. The resolution can be adjusted, for example, by the number of pixels of the virtual camera. Since the imaging region (monitoring region) by the virtual camera is the same, the resolution is higher as the number of pixels is larger.

In addition, the learning image generation unit 911 generates the low-resolution learning data IM4 obtained by imaging the virtual internal space from the same position by the virtual camera with low second resolution. The first resolution and the second resolution are set in advance, for example, such that a resolution magnification that is a ratio of the first resolution to the second resolution becomes equal to or larger than a predetermined value. As can be understood from FIGS. 16 and 17, the high-resolution learning data IM3 and the low-resolution learning data IM4 are different in terms of resolution, but are the same in other points. That is, the learning image generation unit 911 generates the high-resolution learning data IM3 and the low-resolution learning data IM4 with different resolutions (number of pixels), under the same virtual lighting apparatus conditions, at the same virtual camera position, and in the same virtual internal space.

As a result, a set of the high-resolution learning data IM3 and the low-resolution learning data IM4 having different resolutions can be obtained. Note that the set here refers to two pieces of simulation image data (i.e., high-resolution learning data IM3 and low-resolution learning data IM4) in which conditions other than the condition affecting the resolution (e.g., number of pixels) are the same.

The learning image generation unit 911 generates a plurality of sets of the high-resolution learning data IM3 and the low-resolution learning data IM4 by changing, for example, at least one of the position and resolution (number of pixels) of the virtual camera, the conditions (e.g., type, position, light amount, and the like) of the virtual lighting apparatus, and the state of each configuration in the virtual internal space. As the state of each configuration in the virtual internal space, for example, states such as the position of the nozzle 31, the position of the guard 7, and the presence or absence of the substrate W in the virtual internal space can be applied. The values of these conditions may be set in advance, for example, or may be input through a user interface (not illustrated). The learning image generation unit 911 generates a set of the high-resolution learning data IM3 and the low-resolution learning data IM4 under each condition while variously changing these conditions. As a result, a plurality of sets of the high-resolution learning data IM3 and the low-resolution learning data IM4 can be obtained.

Next, the training unit 912 trains a learning model based on the plurality of sets of the high-resolution learning data IM3 and the low-resolution learning data IM4 to generate the learned model LM (step S32: training process).

As described above, if the controller 90 generates the learned model LM based on the simulation image data, the expensive high-performance camera 51 is not required. Therefore, the controller 90 can generate the learned model LM at a lower cost. Furthermore, in the three-dimensional simulation, it is possible to change the resolution more finely in a wider change range than the resolution of the actual high-performance camera 51. Therefore, the controller 90 can easily obtain sets of the high-resolution learning data IM3 and the low-resolution learning data IM4 having various resolution magnifications.

Note that as described above, the controller 90 may generate one learned model LM common to a plurality of monitoring targets, but may also generate a learned model LM for each monitoring target. That is, the learning image generation unit 911 may generate a plurality of sets of the high-resolution learning data IM3 and the low-resolution learning data IM4 according to each monitoring target. For example, the learning image generation unit 911 generates a plurality of sets of the high-resolution learning data IM3 and the low-resolution learning data IM4 for each chuck pin 22. The resolution magnification in each of the plurality of sets corresponding to the chuck pin 22 is equal to or larger than the resolution magnification RM set corresponding to the chuck pin 22. For example, the resolution magnification in each of the plurality of sets corresponding to the chuck pin 22c is equal to or larger than the resolution magnification RMc. In addition, the learning image generation unit 911 may cut out the determination region R1c from the high-resolution learning data IM3 and the low-resolution learning data IM4 as the learning data for the chuck pin 22c. The training unit 912 may generate the learned model LMc for the chuck pin 22c based on a plurality of sets of the determination region R1c of the high-resolution learning data IM3 and the low-resolution learning data IM4. The same applies to the other chuck pins 22.

### <Second embodiment>

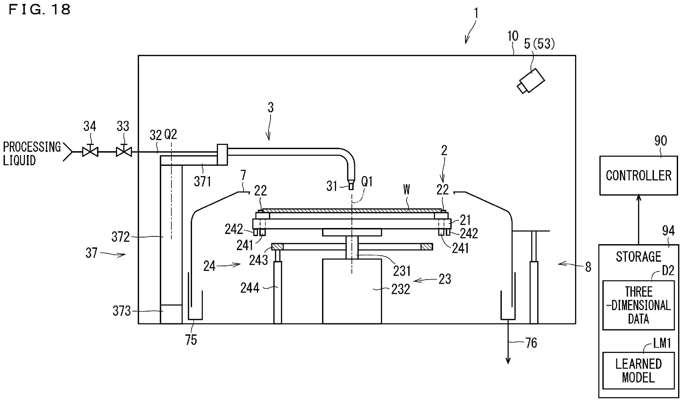

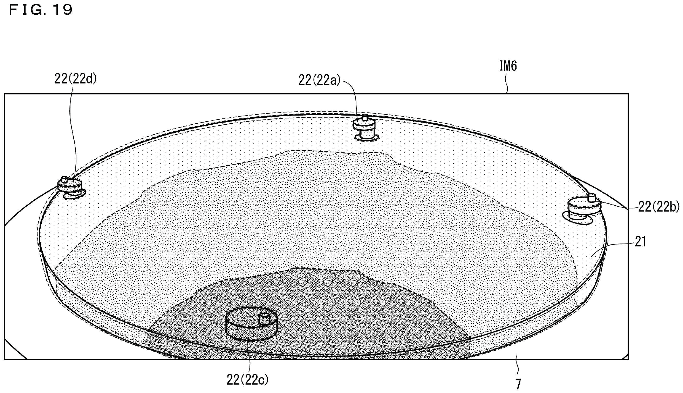

FIG. 18 is a longitudinal sectional view schematically illustrating an example of a configuration of a processing unit 1 according to a second embodiment. In the second embodiment, a camera 5 is a depth camera 53. The depth camera 53 may also be referred to as a distance camera, a three-dimensional camera, a depth sensor, a distance sensor, or a three-dimensional sensor. The depth camera 53 according to the second embodiment measures the depth to each object in a monitoring region and generates monitoring image data IM6 indicating the depth for each pixel. The depth here corresponds to a distance between the depth camera 53 and each object. The monitoring image data IM6 may also be referred to as depth image data or distance image data. FIG. 19 is a diagram schematically illustrating an example of the monitoring image data IM6. In the example of FIG. 19, each pixel is indicated by denser sand-like hatching as an object is closer to the depth camera 53. In the example of FIG. 19, hatching for the guard 7 is omitted. Normally, since the measurement accuracy of the depth camera is not so high, the contour of each object may be more unclear in the monitoring image data IM6. For example, the contour of a chuck pin 22 in the monitoring image data IM6 may be unclear as compared with the example of FIG. 19.

The depth camera 53 may be, for example, a time of flight (TOF) type depth camera. In this case, the depth camera 53 includes a light emitting unit, a light receiving unit, and a calculation unit (not illustrated). The light emitting unit may include a light source that emits measurement light toward the monitoring region and a lens located in front of the light source. The measurement light is not particularly limited, but may be invisible light such as infrared rays, for example. The monitoring region is irradiated with the measurement light from the light source through the lens. The light receiving unit may include a plurality of light receiving elements that receive the measurement light reflected by the monitoring region, and an imaging lens that is located in front of the plurality of light receiving elements and guides the measurement light to each light receiving element. The calculation unit obtains the distance to the object corresponding to each light receiving element based on the difference between the timing at which the light emitting unit emits the measurement light and the timing at which the light receiving unit receives the measurement light. The calculation unit may have, for example, a hardware configuration similar to that of the controller 90. Note that the function of the calculation unit may be included in the controller 90. In this case, a part of the function of the controller 90 functions as the depth camera 53.

As illustrated in FIG. 18, a learned model LM1 is stored in a storage 94. The learned model LM1 is a learned model that performs high-resolution processing on the monitoring image data IM6. The learned model LM1 is, for example, a learned model using deep learning, and a specific algorithm example thereof is similar to that of the learned model LM.

An example of the monitoring method by the processing unit 1 according to the second embodiment is similar to that in FIG. 6. However, in step S1, the light emitting unit of the depth camera 53 irradiates the monitoring region with the measurement light, the light receiving unit of the depth camera 53 receives the measurement light from the monitoring region, and the arithmetic unit of the depth camera 53 generates the monitoring image data IM6 indicating the depth to each object in the monitoring region based on the difference between the irradiation timing by the light emitting unit and the light receiving timing by the light receiving unit.

Next, in step S2, the controller 90 uses the learned model LM1 to enhance the resolution of the monitoring image data IM6 and generate high-resolution image data IM7. Then, the controller 90 monitors the monitoring target based on the high-resolution image data IM7. For example, the controller 90 may identify the position of each chuck pin 22 in high-resolution image data IM7 and determine the appropriateness or inappropriateness of the position of each chuck pin 22. For example, as in the first embodiment, the resolution of normal monitoring image data generated by the depth camera 53 may be enhanced by the learned model LM to generate reference image data, and the reference image data may be stored in the storage 94. The controller 90 may determine the appropriateness or inappropriateness of the chuck pin 22 based on a comparison between the high-resolution image data IM7 and reference image data.

According to this operation, the controller 90 can monitor the monitoring target based on the high-resolution image data IM7 more clearly including the monitoring target. Therefore, the controller 90 can monitor the monitoring target with higher accuracy.

### <Method of generating learned model>

Next, an example of a method of generating the learned model LM1 will be described. The training process of generating the learned model LM1 is executed before the image generation process (step S1), similarly to the first embodiment.

Incidentally, a highly accurate depth camera 53 is difficult to obtain and expensive. Therefore, here, as an example, a simulation image data generated by a three-dimensional simulator is applied to learning data. Here, a learning image generation unit 911 includes a function of a three-dimensional simulator. As in the first embodiment, three-dimensional data D2 is input to the controller 90.

The learning image generation unit 911 has a function of generating simulation image data obtained by a virtual depth camera in a virtual internal space. For example, the learning image generation unit 911 obtains a distance from the position of the virtual depth camera in the virtual internal space to each position of each configuration for each pixel of the virtual depth camera, and generates simulation image data. Since the position of the virtual depth camera is set in advance and each position of each configuration is set with the three-dimensional data D2, the learning image generation unit 911 can calculate the distance to each position. The simulation image data includes a distance from the position of the virtual depth camera in the virtual internal space to each configuration for each pixel.

The learning image generation unit 911 can generate simulation image data with a designated resolution. The resolution can be adjusted, for example, by the number of pixels of the virtual depth camera. Since the measurement area (monitoring region) by the virtual depth camera is the same, the higher the number of pixels, the higher the resolution. For example, the learning image generation unit 911 generates simulation image data with a high first resolution as high-resolution learning data IM8. In addition, the learning image generation unit 911 generates simulation image data with a second resolution lower than the first resolution as low-resolution learning data IM9. Alternatively, the learning image generation unit 911 may down-sample the high-resolution learning data IM8 to generate the low-resolution learning data IM9.

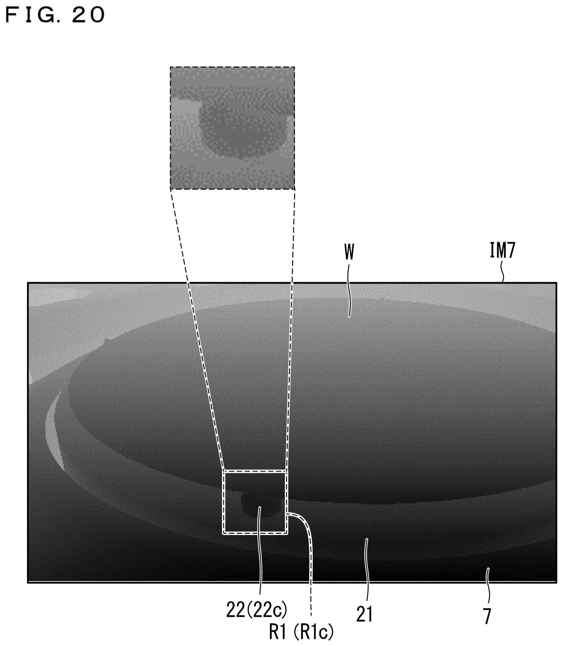

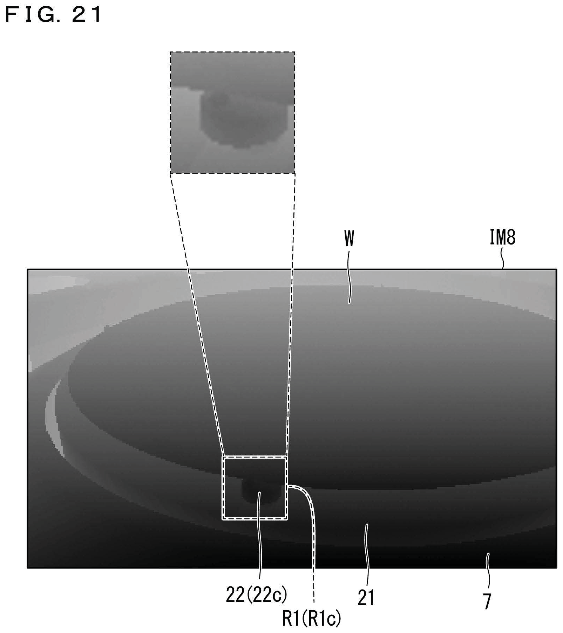

FIG. 20 is a diagram schematically illustrating an example of the high-resolution learning data IM8, and FIG. 21 is a diagram schematically illustrating an example of the low-resolution learning data IM9. In the examples of FIGS. 20 and 21, each pixel is indicated by a color closer to black as the object is closer to the virtual depth camera.

An example of a specific operation of the training process of generating the learned model LM1 is similar to that in FIG. 15. First, in step S31, the learning image generation unit 911 generates a plurality of sets of the high-resolution learning data IM8 and the low-resolution learning data IM9 by three-dimensional simulation, similarly to the first embodiment. The resolution magnification in each set is set to, for example, a predetermined value or more. The learning image generation unit 911 generates a plurality of sets by changing at least one of the resolution (number of pixels) and the position of the virtual depth camera, and the state of each configuration in the virtual internal space.

Next, in step S32, similarly to the first embodiment, the controller 90 trains the learning model using a plurality of sets of the high-resolution learning data IM8 and the low-resolution learning data IM9 to generate the learned model LM1.

As described above, the controller 90 generates the learned model LM1 for enhancing the resolution of the monitoring image data IM6 based on the simulation image data. According to this operation, the learned model LM1 can be generated without requiring the high-performance depth camera 53.

In particular, since the measurement accuracy of the depth camera is not so high, the clarity of the object in the depth image data is low. For example, the clarity is lower than the clarity of the object in captured image data generated by an imaging camera. Therefore, in a case where the depth camera measures the monitoring region and generates the high-resolution learning data IM8, the resolution (clarity) of the high-resolution learning data IM8 is relatively low. Therefore, it is particularly preferable to apply the simulation image data to the learning data used for the learned model LM1 for the depth camera 53. This is because clearer high-resolution learning data IM8 can be easily obtained by three-dimensional simulation.

### <Imaging camera and depth camera>

In the second embodiment, a processing unit 1 may include two cameras 5. The first camera 5 is an imaging camera 52 that receives visible light. The second camera 5 is a depth camera 53. The imaging camera 52 receives light (e.g., visible light) from the monitoring region and generates monitoring image data IM1. The monitoring image data IM1 is captured image data of the monitoring region. The depth camera 53 receives measurement light (e.g., invisible light) reflected from each object in the monitoring region and generates monitoring image data IM6. The monitoring image data IM6 is depth image data indicating the depth to each object in the monitoring region.

Both the learned model LM for the monitoring image data IM1 and the learned model LM1 for the monitoring image data IM6 may be stored in a storage 94.

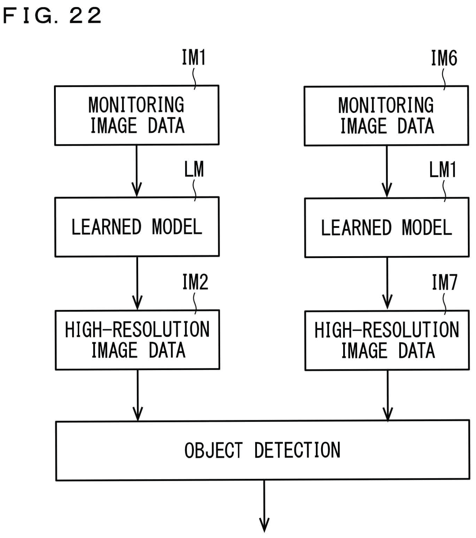

The controller 90 may enhance the resolution of the monitoring image data IM1 using the learned model LM to generate high-resolution image data IM2, and enhance the resolution of the monitoring image data IM6 using the learned model LM1 to generate high-resolution image data IM7. FIG. 22 is a diagram schematically illustrating an example of the operation of the controller 90.

The controller 90 may detect each object in the high-resolution image data IM2 based on the high-resolution image data IM2 and the high-resolution image data IM7. As an algorithm of object detection, for example, an algorithm such as deep learning can be applied. At this time, the controller 90 may combine the high-resolution image data IM2 and the high-resolution image data IM7 to generate synthetic image data. The synthesis here is processing of matching pixels corresponding to the same portion in the monitoring region in the high-resolution image data IM2 and the high-resolution image data IM7, and synthesizing the high-resolution image data IM2 as the captured image data and the high-resolution image data IM7 as the depth image data. That is, each pixel of the synthetic image data includes visual light information at a corresponding position in the monitoring region and depth information up to the position. The controller 90 may perform object detection based on the synthetic image data. As a specific example, the controller 90 may detect a chuck pin 22 based on the synthetic image data. Note that the controller 90 does not necessarily need to synthesize the high-resolution image data IM2 and the high-resolution image data IM7, and may individually execute the object detection algorithm for each of the high-resolution image data IM2 and the high-resolution image data IM7.

According to this embodiment, since the controller 90 synthesizes the high-resolution image data IM2 and the high-resolution image data IM7, it is possible to generate synthetic image data with higher accuracy as compared with the case of synthesizing the monitoring image data IM1 and the monitoring image data IM6. As a result, object detection accuracy can be improved.

Note that the clarity of an object in the monitoring image data IM1 by the imaging camera 52 is higher than the clarity of the object in the monitoring image data IM6 by the depth camera 53. Therefore, the controller 90 does not necessarily need to enhance the resolution of the monitoring image data IM1. For example, the controller 90 may detect an object based on the monitoring image data IM1 and the high-resolution image data IM7. In this case, the learned model LM is unnecessary.

### <A plurality of learned models>

As in the first embodiment, as the learned model LM1 for the monitoring image data IM6, a plurality of learned models LM1 corresponding to a plurality of monitoring targets may be stored in the storage 94. Each learned model LM1 resolves the monitoring image data IM6 at the resolution magnification RM corresponding to the monitoring target to generate high-resolution image data IM7. The resolution magnification RM for each monitoring target is set in advance and stored in the storage 94, for example. For example, a resolution magnification RMa is set for a chuck pin 22a, a resolution magnification RMb is set for a chuck pin 22b, a resolution magnification RMc is set for a chuck pin 22c, and a resolution magnification RMd is set for a chuck pin 22d.

Similarly to the first embodiment, a plurality of learned models LM1 can be generated by training using simulation image data generated by a three-dimensional simulator as learning data.

Hereinabove, the substrate processing apparatus 100 and the substrate processing method have been described in detail, but the above description is an example in all aspects, and the present disclosure is not limited thereto. In addition, the various modifications described above can be applied in combination as long as they do not contradict each other. It is understood that many modifications not illustrated can be assumed without departing from the scope of the present disclosure.

For example, in the above description, the high-resolution learning data IM3 used for generating the learned model LM includes a plurality of monitoring targets (chuck pins 22a to 22d in this case). Then, the controller 90 cuts out the high-resolution learning data IM31 corresponding to each monitoring target from the high-resolution learning data IM3. However, the high-performance camera 51 may image a monitoring region including a single monitoring target. For example, the high-performance camera 51 is mounted in the chamber 10 so as to be able to change the imaging direction. Specifically, the high-performance camera 51 can be fixed to the ceiling of the chamber 10 so as to be rotatable around a vertical rotation axis and rotatable around a horizontal rotation axis. As a result, the processing unit 1 can change the imaging direction of the high-performance camera 51. Then, the high-performance camera 51 may image a monitoring region including a single monitoring target by a zoom function and an imaging direction change function to generate high-resolution learning data. For example, the high-performance camera 51 may generate high-resolution learning data for the chuck pin 22a by imaging a monitoring region not including the chuck pins 22b to 22d but including the chuck pin 22a. The same applies to the chuck pins 22b to 22d.

In the above example, the controller 90 down-samples the high-resolution learning data to convert the high-resolution learning data into the low-resolution learning data. However, the camera 5 may image the monitoring region to generate low-resolution learning data.

### EXPLANATION OF REFERENCE SIGNS

10: chamber
100: substrate processing apparatus
22, 22a to 22d: monitoring target (chuck pin)
5: monitoring camera
51: high-performance camera
52: imaging camera
53: depth camera
D2: three-dimensional data
IM1, IM6: monitoring image data
IM2, IM2a to IM2d, IM7: high-resolution image data
IM3, IM31, IM31a to IM31d, IM8: high-resolution learning data
IM4, IM4a to IM4d, IM9: low-resolution learning data
IM5, IM51a to IM51d: pre-image data
RIM, RIMa to RIMd: reference image data
LM, LM1, LMa to LMd: learned model
RM, RMa to RMd: resolution magnification
S1: image generation process (step)
S2: monitoring process (step)
S11, S31: learning image generation process (step)
S12: resolution reducing process (step)
S13: model generation process (step)
S21: pre-image generation process (step)
S25: reference image generation process (step)
S26, S32: storage process (step)

## Claims

1. A monitoring method for monitoring a monitoring target in a chamber of a substrate processing apparatus that processes a substrate, the monitoring method comprising:
an image generation step in which a monitoring camera receives light from a monitoring region including at least one first monitoring target among a plurality of monitoring targets in said chamber and generates monitoring image data; and
a monitoring step executed after said image generation step to generate high-resolution image data obtained by enhancing resolution of said monitoring image data by using a learned model of resolution enhancement processing, and monitor said first monitoring target based on said high-resolution image data.

2. The monitoring method in a substrate processing apparatus according to claim 1, wherein
in said monitoring step, said high-resolution image data is generated using a first learned model corresponding to said first monitoring target among a plurality of said learned models of the resolution enhancement processing corresponding to said plurality of monitoring targets.

3. The monitoring method in a substrate processing apparatus according to claim 2, wherein
in said image generation step, said monitoring camera receives light from said monitoring region including at least said first monitoring target and a second monitoring target among said plurality of monitoring targets and generates said monitoring image data, and
said monitoring step includes
a step of generating first high-resolution image data in which resolution of a first determination region not including said second monitoring target but including said first monitoring target in said monitoring image data is enhanced using said first learned model as said high-resolution image data, and generating a second high-resolution image data in which resolution of a second determination region not including said first monitoring target but including said second monitoring target in said monitoring image data is enhanced using a second learned model corresponding to said second monitoring target among said plurality of learned models, and a step of monitoring said first monitoring target based on said first high-resolution image data and monitoring said second monitoring target based on said second high-resolution image data.

4. The monitoring method in a substrate processing apparatus according to any one of claims 2 and 3, wherein
in said monitoring step, resolution of said monitoring image data is enhanced at a first resolution magnification set for said first monitoring target among a plurality of resolution magnifications set for said plurality of monitoring targets to generate said high-resolution image data.

5. The monitoring method in a substrate processing apparatus according to claim 4, further comprising
a training step executed before said image generation step to generate said first learned model, wherein
said training step includes:
a learning image generation step in which a high-performance camera having a resolution higher than a resolution of said monitoring camera images said first monitoring target at a plurality of timings in a state where said first monitoring target is more in focus than a second monitoring target among said plurality of monitoring targets to generate a plurality of pieces of high-resolution learning data;
a resolution reduction step in which said plurality of pieces of high-resolution learning data are down-sampled at a magnification equal to or less than an inverse of said first resolution magnification and converted into a plurality of pieces of low-resolution learning data; and
a model generation step of generating said first learned model based on said plurality of pieces of high-resolution learning data and said plurality of pieces of low-resolution learning data.

6. The monitoring method in a substrate processing apparatus according to claim 5, wherein
in said learning image generation step, said high-performance camera images said monitoring region of said monitoring camera.

7. The monitoring method in a substrate processing apparatus according to claim 5, wherein
in said learning image generation step, said first monitoring target that can be displaced is imaged at said plurality of timings at which said first monitoring target is located at different positions to generate said plurality of pieces of high-resolution learning data.

8. The monitoring method in a substrate processing apparatus according to claim 4, further comprising
a training step executed before said image generation step to generate said learned model, wherein
said training step includes:
a learning image generation step of generating a plurality of sets of high-resolution learning data and low-resolution learning data based on three-dimensional data including information regarding a shape of said monitoring target in said chamber; and
a model generation step of generating said learned model based on said plurality of sets of said high-resolution learning data and said low-resolution learning data.

9. The monitoring method in a substrate processing apparatus according to any one of claims 1 to 3, wherein
said monitoring camera includes a depth camera that generates depth image data indicating a distance to said monitoring target as said monitoring image data.

10. The monitoring method in a substrate processing apparatus according to any one of claims 1 to 3, wherein
said monitoring camera includes an imaging camera that receives visible light.

11. The monitoring method in a substrate processing apparatus according to any one of claims 1 to 3, further comprising
a reference image registration step executed before said image generation step to register reference image data, wherein
said reference image registration step includes:
a pre-image generation step of generating pre-image data by said monitoring camera receiving light from said monitoring region;
a reference image generation step of generating, after said pre-image generation step, said reference image data obtained by enhancing resolution of said pre-image data by using said learned model; and
a storage step of causing a storage to record said reference image data, and
in said monitoring step, said first monitoring target is monitored based on a comparison between said high-resolution image data and said reference image data.
